Europäisches Patentamt

European Patent Office

Office européen des brevets

(19)

(11)　**EP 1 333 246 A1**

(12)　**EUROPEAN PATENT APPLICATION**
published in accordance with Art. 158(3) EPC

(43) Date of publication:
　　06.08.2003　Bulletin 2003/32

(51) Int Cl.⁷: **G01B 21/00**, H01L 21/027,
　　G03F 7/20

(21) Application number: **01974891.2**

(22) Date of filing: **19.10.2001**

(86) International application number:
　　**PCT/JP01/09219**

(87) International publication number:
　　**WO 02/033351 (25.04.2002 Gazette 2002/17)**

(84) Designated Contracting States:
　　**AT BE CH CY DE DK ES FI FR GB GR IE IT LI LU
　　MC NL PT SE TR**
　　Designated Extension States:
　　**AL LT LV MK RO SI**

(30) Priority: **19.10.2000　JP 2000319002**

(71) Applicant: **Nikon Corporation
　　Tokyo 100-8331 (JP)**

(72) Inventor: **NAKAJIMA, Shinichi,
　　c/o NIKON CORPORATION
　　Tokyo 100-8331 (JP)**

(74) Representative: **Gill, David Alan
　　W.P. Thompson & Co.,
　　55 Drury Lane
　　London WC2B 5SQ (GB)**

(54)　**POSITION DETECTION METHOD, POSITION DETECTION DEVICE, EXPOSURE METHOD, EXPOSURE SYSTEM, CONTROL PROGRAM, AND DEVICE PRODUCTION METHOD**

(57)　While moving a plurality of areas having a predetermined positional relation with each other on a viewing coordinate system, a degree-of-coincidence calculating unit, based on the result of a viewing unit viewing an object, calculates the degree of inter-area coincidence in at least one pair of viewing-result parts out of viewing-result parts in the plurality of areas in light of given inter-area symmetry therein (steps 151 through 160), and a position-information calculating unit obtains the position information of the object by obtaining the position of the plurality of areas at which the degree of inter-area coincidence, which is a function of the position of the plurality of areas in the viewing coordinate system, takes on, for example, a maximum, (step 161). As a result, the position information of the object is accurately detected.

Fig. 16

**Description**

*TECHNICAL FIELD*

The present invention relates to a position detecting method and unit, an exposure method and apparatus, a control program, and a device manufacturing method and more specifically to a position detecting method and unit for detecting the position of a mark formed on an object, an exposure method that uses the position detecting method, an exposure apparatus comprising the position detecting unit, a storage medium storing a control program that embodies the position detecting method, and a device manufacturing method that uses the exposure method.

*BACKGROUND ART*

To date, in a lithography process for manufacturing semiconductor devices, liquid crystal display devices, or the like, exposure apparatuses have been used which transfer a pattern formed on a mask or reticle (generically referred to as a "reticle" hereinafter) onto a substrate such as a wafer or glass plate (hereinafter, generically referred to as a "substrate" or "wafer" as needed) coated with a resist, through a projection optical system. As such an exposure apparatus, a stationary-exposure-type projection exposure apparatus such as the so-called stepper, or a scanning-exposure-type projection exposure apparatus such as the so-called scanning stepper is mainly used. Such an exposure apparatus needs to accurately align a reticle with a wafer before exposure.

Therefore, the positions of the reticle and the wafer need to be very accurately detected. In detecting the position of the reticle exposure light is usually used. For example, VRA (Visual Reticle Alignment) technique is adapted which illuminates a reticle alignment mark formed on the reticle with exposure light and processes the image data of the reticle alignment mark picked up by, e.g., CCD camera to measure the position of the mark. Furthermore, in aligning the wafer, LSA (Laser Step Alignment) or FIA (Field Image Alignment) technique is adapted. The LSA technique illuminates a wafer alignment mark, which is a row of dots, on a wafer with laser light and detects the position of the mark using light diffracted or scattered by the mark, and the FIA technique illuminates a wafer alignment mark on a wafer with light whose wavelength broadly ranges such as halogen lamp and processes the image data of the alignment mark picked up by, e.g., CCD camera to detect the position of the mark. Due to demand for increasingly improved accuracy the FIA technique is mainly used because it is tolerant to deformation of the mark and unevenness of resist coating.

An optical alignment technique such as the above VRA, LSA, and FIA, first, obtains the image signal (may be one-dimensional) of an area including a mark and identifies a portion reflecting the mark in the image signal and extracts the image signal's portion (hereinafter, called a " mark signal") corresponding to the mark image.

As a method of extracting the mark signal, there are

(a) an edge-extraction technique (prior art 1) which differentiates the image signal, detects positions where the differentiated image signal takes on a local maximum (or minimum) corresponding to the edge positions of the mark and identifies an image signal's portion that coincides with the mark's structure planned in design (the distribution of edge positions) as the mark signal,
(b) a pattern-matching technique (prior art 2) which identifies the mark signal by using normalized correlation between a template pattern, which was determined from the mark's structure planned in design, and the image signal, and (c) a self-correlation technique (prior art 3) which, if the mark's structure is symmetry with respect to its center line, while moving an axis parallel to the center line in the image area according to which the image signal is divided into two portions, transforms coordinates of one of the two portions by flipping and calculates normalized correlation between the coordinate-transformed signal portion and the other signal portion and identifies the mark signal by using the normalized correlation, which is a function of the position of the axis.

Moreover, in executing any of the above prior-art techniques 1 through 3, the image signal has to be obtained when focusing on the mark, and thus focus measurement is needed which usually uses a method of acquiring information about the focusing state disclosed in, for example, Japanese Patent Application Laid-Open No. 10-223517. In that method (prior art 4), first, two focus measurement features (e.g. slit-like feature) are projected onto outside the area from which the mark signal is obtained; light beams from the focus measurement features are reflected and each divided by a pupil dividing prism or the like into two portions, each of which is imaged. And the distances between the four images on the image plane are measured to obtain information about the focusing state. In the measurement, the distances between the respective centroids of the images on the image plane may be measured, or after detecting the respective edge-positions of the images, the distances between the images are measured using the edge-positions.

As the unevenness of the surfaces of layers covering marks decreases due to the advance of flattening technology such as chemical and mechanical polishing, hereinafter called "CMP", because of multi-interference by a resist film the part of a viewed signal corresponding to each mark edge may be a phase-object waveform with two signal-edges or a light-and-shade-object waveform with one signal-edge depending on slight unevenness and variation of the thickness of the resist film. Therefore, marks on reticles or wafers that have gone through the same manufacturing process may behave differently, some of which do as a phase mark and others do as a light-and-shade mark. Furthermore, a same mark may behave likewise depending on the state of focusing when picking up its image.

Therefore, in order to accurately detect a mark's position by use of the edge extraction technique of prior art 1, the number and the type of signal-edges, e.g. an inner-edge in a line-and-space pattern, need to be manually specified before processing the image signal of the mark. Moreover, it may not vary according to lot or wafer whether a mark-edge's signal waveform is a phase-object waveform or a light-and-shade-object waveform, and there may be phase-object waveforms and light-and-shade-object waveforms in a wafer and even in a mark, in which case for each mark whose position is to be detected or for each mark-edge the foregoing specification is needed, so that marks' positions cannot be readily detected.

In addition, when using the pattern matching technique of prior art 2, in light of the uncertainty whether it is a phase mark or a light-and-shade mark, the correlations between a plurality of templates provided that each cover the entire mark image area and the image signal may be computed so that the highest one of the correlations is used to detect the position. In order to improve the accuracy in detecting the position, however, a number of different templates need to be provided, and thus there are several problems in terms of a workload in preparing the templates and a storage resource for storing the templates.

Moreover, when using the pattern matching technique, if the mark is a line-and-space mark, the correlation in an image area having a width close to the line's width between a template corresponding to the line and the image signal may be examined to extract an image portion corresponding to the line and detect the position thereof. According to knowledge obtained from the studies by the inventor, especially in the case of a phase mark, the correlation often takes on a higher value even when the template does not coincide with the mark. Therefore, an algorism for accurately detecting the true position of the mark is necessary, so that the process becomes complex, and thus it is difficult to quickly measure the mark's position.

Further, the self-correlation technique of prior art 3 is a method where the symmetry is detected and which does not need a template and is tolerant to defocus and process variation, and thus can only be applied to marks having a symmetric structure with the result that the amount of computing the correlation over the entire mark area is large.

Yet further, in the focus measurement of prior art 4 the shape of an image on the pupil varies according to the image of focus measurement feature, e.g. slit-like feature, projected on the wafer, so that large error may occur in centroid and edge measurement. Thus precise focus measurement is difficult.

Meanwhile, as semiconductor devices have become increasingly highly integrated and fine in circuit pattern, unevenness of the surfaces of layers covering alignment marks has decreased and the requirement for the accuracy in detecting alignment marks has become stricter. That is, a new technology is expected for very accurate detection of positions of marks with low unevenness.

This invention was made under such circumstances, and a first purpose of the present invention is to provide a position detecting method and unit that can accurately detect positions of marks.

Further, a second purpose of the present invention is to provide an exposure apparatus that can perform very accurate exposure.

Still further, a third purpose of the present invention is to provide a storage medium storing a program capable of accurately detecting position information of an object.

Yet further, a fourth purpose of the present invention is to provide a device manufacturing method that can manufacture highly integrated devices having a fine pattern.

### DISCLOSURE of INVENTION

According to a first aspect of the present invention, there is provided a position detecting method with which to detect position information of an object, the detecting method comprising a viewing step where the object is viewed; an area-coincidence degree calculating step where a degree of area-coincidence in a part of the viewing result in at least one area out of a plurality of areas having a predetermined positional relationship on a viewing coordinate system for the object is calculated in light of given symmetry therein; and a position information calculating step where position information of the object is calculated based on the degree of area-coincidence. Here, the "given symmetry" refers to inter-area symmetry between a plurality of areas and intra-area symmetry in a given area. The "position information of an object" refers to one- or two-dimensional position information of the object in the viewing field and information of position in the optical-axis direction of, e.g., an imaging optical system for viewing it (focus/defocus position information), which axis direction crosses the viewing field.

According to this, while moving a plurality of areas having a predetermined positional relation with each other on a viewing coordinate system, the step of calculating a degree of area-coincidence, based on the result of viewing an object in the viewing step, calculates the degree of area-coincidence in a part of the viewing result in at least one area out of a plurality of areas having a predetermined positional relation with each other on a viewing coordinate system, in light of given symmetry therein, and the step of calculating position information obtains the position information of the object by obtaining the position of the at least one area at which the degree of area-coincidence, which is a function of the position of the at least one area in the viewing coordinate system, takes on, for example, a maximum. Therefore, the position information of the object can be accurately detected without a template by using the fact that the degree of area-coincidence takes on, for example, a maximum when the at least one area is in a specific position in the viewing result. Further, because the degree of area-coincidence is calculated only for some of the areas, the position information of the object can be quickly detected.

In the position detecting method according to this invention, in the viewing step a mark formed on the object is viewed, and in the position information calculating step, position information of the mark may be calculated. In this case, by providing a position detection mark (e.g. a line-and-space mark, etc.) formed on the object, the position information of the mark and thus the position information of the object can be accurately detected.

Further, the plurality of areas are determined according to the shape of the mark. By determining the positional relation between the plurality of areas according to, for example, characteristic symmetry of the mark's structure and examining the degree of area-coincidence in a part of the viewing result in the at least one area in light of the characteristic symmetry, the position information of the mark can be detected.

In the position detecting method according to this invention, the degree of area-coincidence may be a degree of inter-area coincidence in at least one pair of viewing-result parts out of respective viewing-result parts in the plurality of areas, the degree of inter-area coincidence being calculated in light of given inter-area symmetry therein. Here, "given inter-area symmetry" refers to, for example, when the plurality of areas are one-dimensional, translational identity, symmetry, similarity, etc., and when the plurality of areas are two-dimensional, translational identity, rotational symmetry, symmetry, similarity, etc.

Here, the number of the plurality of areas may be three or greater, and in the area-coincidence degree calculating step, a degree of inter-area coincidence may be calculated for each of a plurality of pairs selected from the plurality of areas. In this case, because the degree of inter-area coincidence is calculated for the plurality of pairs, an accidental increase over the original value in the degree of inter-area coincidence in a pair of areas due to noise, etc., can be detected. By, for example, calculating the product or mean of the degrees of inter-area coincidence for the plurality of pairs, an overall degree of coincidence for the plurality of areas is obtained which is less affected by noise, etc.

Yet further, the area-coincidence degree calculating step may comprise a coordinate transforming step where coordinates of the viewing-result part in one area of which a degree of inter-area coincidence is to be calculated are transformed by use of a coordinate-transforming method corresponding to the type of symmetry defined by a relation with the other area; and an inter-area coincidence degree calculating step where the degree of inter-area coincidence is calculated based on the coordinate-transformed, viewing-result part in the one area and the viewing-result part in the other area. In this case by providing a means for transforming coordinates according to inter-area symmetry expected, the degree of inter-area coincidence can be readily calculated.

In this case, the calculating of the degree of inter-area coincidence may be performed by calculating a normalized correlation coefficient between the coordinate-transformed, viewing-result part in the one area and the viewing-result part in the other area. In this case, because the normalized correlation coefficient accurately represents the degree of inter-area coincidence, the degree of inter-area coincidence can be accurately calculated. It is understood that the larger value of the normalized correlation means the higher degree of inter-area coincidence.

Still further, the calculating of the degree of inter-area coincidence may be performed by calculating the difference between the coordinate-transformed, viewing-result part in the one area and the viewing-result part in the other area. Here, the difference between the viewing-result parts in the two areas means the sum of the absolute values of the differences between values of the viewing-result at points in the one area and values of the viewing-result at corresponding points in the other area. In this case, because the computation of the difference between the viewing-result parts in the two areas, which directly represents the degree of coincidence, is simple, the degree of inter-area coincidence can be readily calculated. It is understood that the smaller value of the difference between the viewing-result parts in the two areas means the higher degree of inter-area coincidence.

Further, the calculating of the degree of inter-area coincidence may be performed by calculating at least one of total variance, which is the sum of variances between values at points in the coordinate-transformed, viewing-result part in the one area and values at corresponding points in the viewing-result part in the other area, and standard deviation obtained from the total variance. In this case, by a simple computation of the total variance and standard deviation and analysis of the computing result the degree of inter-area coincidence can be readily calculated. This method is handy because the degree of inter-area coincidence between three or more than three areas can be calculated at one time. It is understood that the smaller value of the total variance or standard deviation means the higher degree of inter-area coincidence.

Further, in the area-coincidence degree calculating step, while moving the plurality of areas on the viewing coordinate system with keeping positional relation between the plurality of areas, the degree of inter-area coincidence may be calculated. This method is used when the centerline's position of symmetry in the result of viewing an object whose position is to be detected is known like in detecting a mark formed on an object and having a predetermined shape.

Still further, in the area-coincidence degree calculating step, while moving the plurality of areas on the viewing coordinate system with changing positional relation between the areas, the degree of inter-area coincidence may be calculated. This method is used when the centerline's position of symmetry in the result of viewing an object whose position is to be detected is unknown. Moreover, in the case of measuring the distance between two features apart from each other in a predetermined direction like in the detection of defocus amount, in the area-coincidence degree calculating step, the two areas may be moved in opposite directions to each other along a given axis-direction to change the distance between the two areas.

Yet further, in the area-coincidence degree calculating step, for the viewing-result part in at least one area of the plurality of areas, a degree of intra-area coincidence may be further calculated in light of given symmetry therein, and in the step of calculating position information, position information of the object may be obtained based on the degree of inter-area coincidence and the degree of intra-area coincidence. In this case, when calculating only a degree of inter-area coincidence in light of given inter-area symmetry is not sufficient to accurately detect the position information, by judging from a degree of intra-area coincidence calculated in light of given intra-area symmetry therein and the degree of inter-area coincidence, the position information of the object can be accurately detected.

In the position detecting method according to this invention, the degree of area-coincidence may be a degree of intra-area coincidence in at least one viewing-result part out of viewing-result parts in the plurality of areas, the degree of intra-area coincidence being calculated in light of given intra-area symmetry. Here, "given intra-area symmetry" refers to, when the area is one-dimensional, mirror symmetry, etc., and, when the area is two-dimensional, rotational symmetry, mirror symmetry, etc. Herein, mirror symmetry, when the area is one-dimensional, and 180-degree-rotational symmetry and mirror symmetry when the area is two-dimensional are generically called "intra-area symmetry".

In the same as with the inter-area symmetry, the area-coincidence degree calculating step may comprise a coordinate transforming step where coordinates of the viewing-result part in an area for which the degree of intra-area coincidence is to be calculated are transformed by use of a coordinate-transforming method corresponding to the given intra-area symmetry; and an intra-area coincidence degree calculating step where the degree of intra-area coincidence is calculated based on the non-coordinate-transformed, viewing-result part and the coordinate-transformed, viewing-result part.

The calculating of the degree of intra-area coincidence may be performed by calculating (a) a normalized correlation coefficient between the non-coordinate-transformed, viewing-result part and the coordinate-transformed viewing-result part; (b) the difference between the non-coordinate-transformed, viewing-result part and the coordinate-transformed, viewing-result part, or (c) at least one of total variance, which is the sum of variances between values at points of the non-coordinate-transformed, viewing-result part and values at corresponding points of the coordinate-transformed, viewing-result part, and standard deviation obtained from the total variance.

In the area-coincidence degree calculating step, while moving an area for which the degree of intra-area coincidence is to be calculated on the viewing coordinate system, the degree of intra-area coincidence may be calculated. In this case, when for two or more areas the degree of intra-area coincidence is to be calculated, the two or more areas are moved on the viewing coordinate system (a) with keeping positional relation between the two or more areas, or (b) with changing positional relation between the two or more areas.

In the position detecting method according to this invention, in the viewing step an N-dimensional image signal viewed may be projected onto an M-dimensional space to obtain the viewing result, where N is a natural number of two or greater and M is a natural number smaller than N. In this case, because a computation is performed on the M-dimensional image signal, which has a less amount of data than the N-dimensional image signal, the position information of the object can be readily detected.

According to a second aspect of the present invention, there is provided a position detecting unit which detects position information of an object, the detecting unit comprising a viewing unit that views the object; a degree-of-coincidence calculating unit that calculates a degree of area-coincidence in a part of the viewing result in at least one area out of a plurality of areas having a predetermined positional relation with each other on a viewing coordinate system, in light of given symmetry therein; and a position-information calculating unit that calculates position information of the object based on the degree of area-coincidence.

According to this, based on the result of a viewing unit viewing an object, a degree-of-coincidence calculating unit, with moving a plurality of areas having a predetermined positional relation with each other on a viewing coordinate system, calculates a degree of area-coincidence in a part of the viewing result in at least one area out of the plurality of areas in light of given symmetry therein, and a position-information calculating unit calculates position information of the object based on the degree of area-coincidence, which is a function of the position of the at least one area in the viewing coordinate system. That is, the position detecting unit of this invention can accurately detect position information of an object because it uses the position detecting method of this invention.

In the position detecting unit according to this invention, the viewing unit may comprise a unit that picks up an image of a mark formed on the object. In this case, the viewing result is an optical image picked up by the picking-up unit, and the structure of the viewing unit is simple.

In the position detecting unit according to this invention, the degree of area-coincidence may be a degree of inter-area coincidence in at least one pair of viewing-result parts out of respective viewing-result parts in the plurality of areas, the degree of inter-area coincidence being calculated in light of given inter-area symmetry therein, and the degree-of-coincidence calculating unit may comprise a coordinate-transforming unit that transforms coordinates of the viewing-result part in one area of which a degree of inter-area coincidence is to be calculated, by use of a coordinate-transforming method corresponding to the type of symmetry defined by a relation with the other area; and a processing unit that calculates the degree of inter-area coincidence based on the coordinate-transformed, viewing-result part in the one area and the viewing-result part in the other area. In this case, a coordinate-transforming unit transforms coordinates of the viewing-result part in one area of two areas by use of a coordinate-transforming method corresponding to the type of symmetry between the two areas so that modified coordinates in the one area are the same as corresponding coordinates in the other area, and a processing unit calculates the degree of inter-area coincidence with comparing the value of the coordinate-transformed, viewing-result part at each point in the one area and the value of the viewing-result part at a corresponding point in the other area. Therefore, the degree of inter-area coincidence can be readily calculated, and the position information of the object can be detected quickly and accurately.

In the position detecting unit according to this invention, the degree of area-coincidence may be a degree of intra-area coincidence in at least one viewing-result part out of viewing-result parts in the plurality of areas, the degree of intra-area coincidence being calculated in light of given intra-area symmetry, and the degree-of-coincidence calculating unit may comprise a coordinate-transforming unit that transforms coordinates of the viewing-result part in an area for which the degree of intra-area coincidence is to be calculated, by use of a coordinate-transforming method corresponding to the given intra-area symmetry; and a processing unit that calculates the degree of intra-area coincidence based on the non-coordinate-transformed, viewing-result part and the coordinate-transformed, viewing-result part. In this case, a coordinate-transforming unit transforms coordinates of the viewing-result part in an area by use of a coordinate-transforming method corresponding to the given intra-area symmetry so that modified coordinates in the area are the same as corresponding, non-modified coordinates in the area, and a processing unit calculates the degree of intra-area coincidence with comparing the values of the non-coordinate-transformed, viewing-result part and the coordinate-transformed, viewing-result part at each coordinate point. Therefore, the degree of intra-area coincidence can be readily calculated, and the position information of the object can be detected quickly and accurately.

According to a third aspect of the present invention, there is provided an exposure method with which to transfer a given pattern onto divided areas on a substrate, the exposure method comprising a position calculating step of detecting positions of position-detection marks formed on the substrate by use of the position detecting method of this invention and calculating position information of the divided areas on the substrate; and a transferring step of transferring the pattern onto the divided areas with controlling the position of the substrate based on position information of the divided areas calculated in the detecting and calculating step.

According to this, in the detecting and calculating step, positions of position-detection marks formed on the substrate are detected by use of the position detecting method of this invention, and based on the result, position information of the divided areas on the substrate is calculated. And in the transferring step a given pattern is transferred onto the divided areas with controlling the position of the substrate based on position information of the divided areas. Therefore, the given pattern can be accurately transferred onto the divided areas.

According to a fourth aspect of the present invention, there is provided an exposure apparatus which transfers a given pattern onto divided areas on a substrate, the exposure apparatus comprising a stage unit that moves the substrate along a movement plane; and a position detecting unit according to this invention that is mounted on the stage unit and detects position of a mark on the substrate. According to this, a position detecting unit according to this invention accurately detects position of a mark on the substrate and thus position of the substrate. Therefore, a stage unit can move the substrate based on the position of the substrate calculated accurately, so that a given pattern can be accurately transferred onto divided areas on the substrate.

According to a fifth aspect of the present invention, there is provided a control program which is executed by a position detecting unit that detects position information of an object, the control program comprising a procedure of calculating a degree of area-coincidence in a part of the viewing result in at least one area out of a plurality of areas having a predetermined positional relationship on a viewing coordinate system for the object, in light of given symmetry therein; and a procedure of calculating position information of the object based on the degree of area-coincidence.

According to this, by a position detecting unit executing the control program, position information of an object is detected according to the position detecting method of this invention. Therefore, without using a template, etc.,

position information of the object can be detected accurately and also quickly because only part of the viewing result is used in calculating the degree of coincidence.

In the control program of this invention, in the calculating of a degree of area-coincidence, a degree of area-coincidence in a result of viewing a mark formed on the object may be calculated in light of the given symmetry therein; and in the calculating of position information of the object, position information of the mark may be calculated. In this case, by providing position detection marks formed on the object, the position information of the marks and thus the position information of the object can be accurately detected.

Further, the plurality of areas may be determined according to the shape of the mark.

Further, in the control program according to this invention, the degree of area-coincidence may be a degree of inter-area coincidence in at least one pair of viewing-result parts out of respective viewing-result parts in the plurality of areas, the degree of inter-area coincidence being calculated in light of given inter-area symmetry therein.

Here, in calculating of the degree of inter-area coincidence, (a) while moving the plurality of areas on the viewing coordinate system with keeping positional relation between the areas, the degree of inter-area coincidence may be calculated, or (b) while moving the plurality of areas on the viewing coordinate system with changing positional relation between the areas, the degree of inter-area coincidence may be calculated.

In the control program according to this invention, the degree of area-coincidence may be a degree of intra-area coincidence in at least one viewing-result part out of viewing-result parts in the plurality of areas, the degree of intra-area coincidence being calculated in light of given intra-area symmetry.

Here, in calculating of the degree of intra-area coincidence, while moving an area for which the degree of intra-area coincidence is to be calculated on the viewing coordinate system, the degree of intra-area coincidence may be calculated.

In this case, when for two or more areas the degree of intra-area coincidence is to be calculated, the two or more areas may be moved on the viewing coordinate system (a) with keeping positional relation between the two or more areas or (b) with changing positional relation between the two or more areas.

Moreover, by performing exposure by use of the exposure method of this invention in a lithography process, fine sub-patterns can be accurately formed on a substrate with good overlay accuracy between them, and highly integrated micro-devices can be manufactured with high yield and improved productivity. Therefore, according to another aspect of the present invention, there is provided a device manufacturing method using the exposure method of this invention.

## BRIEF DESCRIPTION OF THE DRAWINGS

In the accompanying drawings:

Fig. 1 is a schematic view showing the construction of an exposure apparatus according to a first embodiment;
Fig. 2 is a schematic view showing the construction of an alignment microscope in Fig. 1;
Figs. 3A and 3B are a view showing the structures of a field stop and a shading plate in Fig. 2 respectively;
Fig. 4 is a schematic view showing the construction of a stage control system of the exposure apparatus in Fig. 1;
Fig. 5 is a schematic view showing the construction of a main control system of the exposure apparatus in Fig. 1;
Fig. 6 is a flow chart showing the procedure of wafer alignment by the exposure apparatus in Fig. 1;
Figs. 7A and 7B are views for explaining an example of a search alignment mark;
Fig. 8 is a flow chart showing the process in a defocus-amount measuring subroutine of Fig. 6;
Fig. 9 is a view for explaining illumination areas on a wafer;
Fig. 10A is a view for explaining an image picked up in the measuring of defocus-amount, and Fig. 10B is a view for explaining the relation between defocus-amount (DF) and the pitch of images;
Fig. 11A is a view for explaining a signal waveform in the measuring of defocus-amount, and Fig. 11B is a view for explaining areas in the measuring of defocus-amount;
Fig. 12 is a flow chart showing the process concerning a first area (ASL1) in Fig. 8 in the defocus-amount measuring subroutine;
Figs. 13A through 13C are views for explaining how the signal waveforms in the areas of Fig. 11B vary during the areas scanning;
Fig. 14 is a view for explaining the relation between position (LW1) and the degree of inter-area coincidence;
Figs. 15A and 15B are views for explaining an exemplary structure of the search alignment mark and a typical example of its viewed waveform respectively;
Fig. 16 is a flow chart showing the process in a mark-position detecting subroutine in Fig. 6;
Fig. 17 is a view for explaining areas in detecting a mark's position;
Figs. 18A through 18C are views for explaining how the signal waveforms in the areas of Fig. 17 vary during the areas scanning;

Fig. 19 is a view for explaining the relation between position ($YPP_1$) and the degree of inter-area coincidence;

Figs. 20A through 20C are views for explaining a modified example 1 from the first embodiment;

Fig. 21 is a view for explaining the relation between areas and the image in a modified example 2 from the first embodiment;

Fig. 22 is a view for explaining the two-dimensional image of a mark used in a second embodiment;

Fig. 23 is a flow chart showing the process in a mark-position detecting subroutine in the second embodiment;

Fig. 24 is a view for explaining areas in detecting a mark's position in the second embodiment;

Fig. 25 is a view for explaining image signals in the areas in the second embodiment;

Fig. 26 is a view for explaining the relation between position ($XPP_1$, $YPP_1$) and the degree of inter-area coincidence;

Figs. 27A and 27B are views for explaining a modified example from the second embodiment;

Figs. 28A and 28B are views for explaining modified examples from the position detection mark in the second embodiment;

Figs. 29A through 29E are views for explaining the process including CMP process and forming a Y-mark;

Fig. 30 is a flow chart for explaining the method of manufacturing devices using the exposure apparatus of the first or second embodiment; and

Fig. 31 is a flow chart showing the process in the wafer process step of Fig. 30.


### Best Mode for Carrying out the Invention


«A first embodiment»


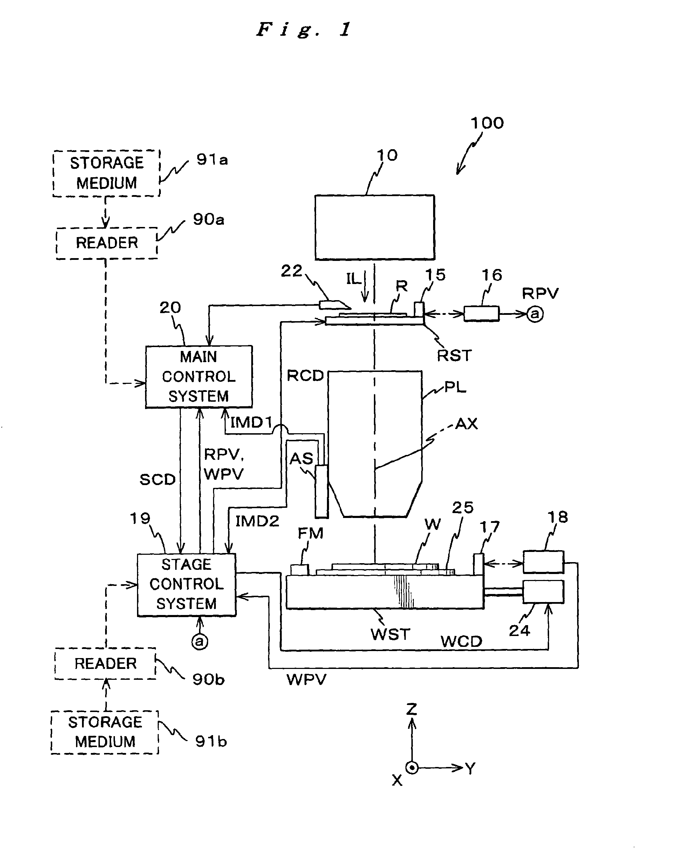

A first embodiment of the present invention will be described below with reference to Figs. 1 to 19.

Fig. 1 shows the schematic construction and arrangement of an exposure apparatus 100 according to this embodiment, which is a projection exposure apparatus of a step-and-scan type. This exposure apparatus 100 comprises an illumination system 10, a reticle stage RST for holding a reticle R, a projection optical system PL, a wafer stage WST as a stage unit on which a wafer W as a substrate is mounted, an alignment detection system AS as a viewing unit (pick-up unit), a stage control system 19 for controlling the positions and yaws of the reticle stage RST and the wafer stage WST, a main control system 20 to control the whole apparatus overall and the like.

The illumination system 10 comprises a light source, an illuminance-uniforming optical system including a fly-eye lens and the like, a relay lens, a variable ND filter, a reticle blind, a dichroic mirror, and the like (none are shown). The construction of such an illumination system is disclosed in, for example, Japanese Patent Application Laid-Open No. 10-112433. The disclosure in the above Japanese Patent Application Laid-Open is incorporated herein by reference as long as the national laws in designated states or elected states, to which this international application is applied, permit. The illumination system 10 illuminates a slit-like illumination area defined by the reticle blind BL on the reticle R having a circuit pattern thereon with exposure light IL having almost uniform illuminance.

On the reticle stage RST, a reticle R is fixed by, e.g., vacuum chuck. The retilce stage RST can be finely driven on an X-Y plane perpendicular to the optical axis (coinciding with the optical axis AX of a projection optical system PL) of the illumination system 10 by a reticle-stage-driving portion (not shown) constituted by a magnetic-levitation-type, two-dimensional linear actuator in order to position the reticle R, and can be driven at specified scanning speed in a predetermined scanning direction (herein, parallel to a Y-direction). Furthermore, in the present embodiment, because the magnetic-levitation-type, two-dimensional linear actuator comprises a Z-driving coil as well as a X-driving coil and a Y-driving coil, the reticle stage RST can be driven in a Z-direction.

The position of the reticle stage RST in the plane where the stage moves is always detected through a movable mirror 15 by a reticle laser interferometer 16 (hereinafter, referred to as a "reticle interferometer") with resolving power of, e.g., 0.5 to 1nm. The position information (or speed information) RPV of the reticle stage RST is sent from the reticle interferometer 16 through the stage control system 19 to the main control system 20, and the main control system 20 drives the reticle stage RST via the stage control system 19 and the reticle-stage-driving portion (not shown) based on the position information (or speed information) RPV of the reticle stage RST.

Disposed above the reticle R are a pair of reticle alignment systems 22 (all are not shown) which each comprise a downward illumination system for illuminating a mark to be detected with illumination light having the same wavelength as exposure light IL and an alignment microscope for picking up the images of the mark to be detected. The alignment microscope comprises an imaging optical system and a pick-up device, and the picking-up results of the alignment microscope are sent to the main control system 20, in which case a deflection mirror (not shown) for guiding detection light from the reticle R is arranged to be movable. Before the start of exposure sequence, a driving unit (not shown), according to instructions from the main control system 20, makes the deflection mirror integrally with the reticle alignment system 22 retreat from the optical path of exposure light IL. The reticle alignment system 22 in Fig. 1 shows representatively the pair.

The projection optical system PL is arranged underneath the reticle stage RST in Fig. 1, whose optical axis AX is parallel to the Z-axis direction, and is, for example, a refraction optical system that is telecentric bilaterally and that has a predetermined reduction ratio, e.g. 1/5 or 1/4. Therefore, when the illumination area of the reticle R is illuminated with the illumination light IL from the illumination system 10, the reduced image of the circuit pattern's part in the illumination area on the reticle R is formed by the illumination light IL having passed through the reticle R and the projection optical system PL on the wafer W coated with a resist (photosensitive material), the reduced image being an inverted image.

The wafer stage WST is arranged on a base (not shown) below the projection optical system in Fig. 1, and on the wafer stage WST a wafer holder 25 is disposed on which a wafer W is fixed by, e.g., vacuum chuck. The wafer holder 25 is constructed to be able to be tilted in any direction with respect to a plane perpendicular to the optical axis of the projection optical system PL and to be able to be finely moved parallel to the optical axis AX (the Z-direction) of the projection optical system PL by a driving portion (not shown). The wafer holder 25 can also rotate finely about the optical axis AX.

The wafer stage WST is constructed to be able to move not only in the scanning direction (the Y-direction) but also in a direction perpendicular to the scanning direction (the X-direction) so that a plurality of shot areas on the wafer can be positioned at an exposure area conjugate to the illumination area, and a step-and-scan operation is performed in which performing scanning-exposure of a shot area on the wafer and moving a next shot area to the exposure starting position are repeated. And the wafer stage WST is driven in the X- and Y-directions by a wafer-stage driving portion 24 comprising a motor, etc.

The position of the wafer stage WST in the X-Y plane is always detected through a movable mirror 17 by a wafer laser interferometer with resolving power of, e.g., 0.5 to 1nm. The position information (or speed information) WPV of the wafer stage WST is sent through the stage control system 19 to the main control system 20, and based on the position information (or speed information) WPV, the main control system 20 controls the movement of the wafer stage WST via the stage control system 19 and wafer-stage driving portion 24.

Moreover, fixed near the wafer W on the wafer stage WST is a reference mark FM whose surface is set at the same height as the surface of the wafer W, on which surface various reference marks for alignment including a pair of first reference marks for reticle alignment and a second reference mark for base-line measurement are formed.

The alignment detection system AS is a microscope of an off-axis type which is provided on the side face of the projection optical system PL and which comprises a light source 61, an illumination optical system 62, a first imaging optical system 70, a pick-up device 74 constituted by CCD for viewing marks and the like, a shading plate 75, a second imaging optical system 76 and a pick-up device 81 constituted by CCD and the like. The construction of such an alignment microscope AS is disclosed in detail in, for example, Japanese Patent Application Laid-Open No. 10-223517. The disclosure in the above Japanese Patent Application Laid-Open is incorporated herein by reference as long as the national laws in designated states or elected states, to which this international application is applied, permit.

The light source 61 is a halogen lamp or the like emitting a light beam having a broad range of wavelengths, and is used both for viewing marks and for focusing as described later.

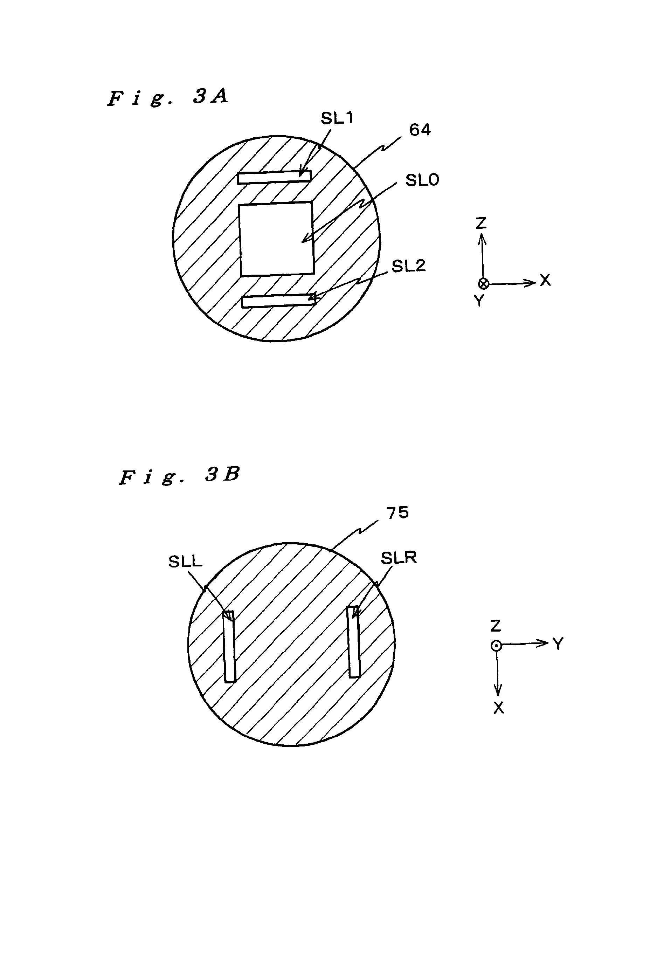

The illumination optical system 62 comprises a condenser lens 63, a field stop 64, an illumination relay lens 66, a beam splitter 68, and a first objective lens 69, and illuminates the wafer W with light from the light source 61. The field stop 64, as shown in Fig. 3A, comprises a square main aperture SL0 in the center thereof and rectangular, slit-like secondary apertures SL1, SL2 on both sides in the Z-direction of the main aperture SL0.

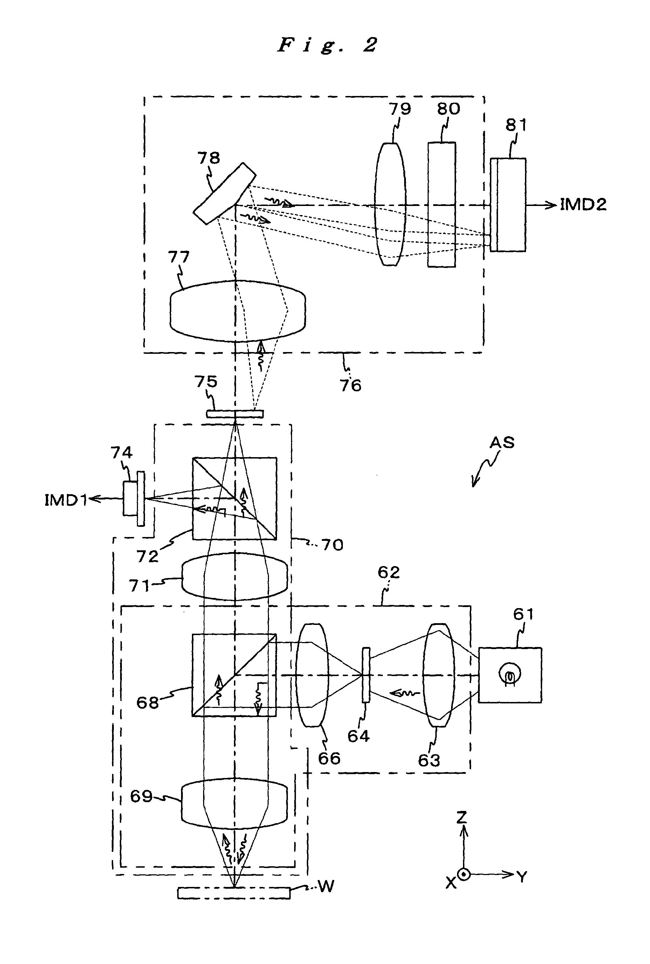

Referring back to Fig. 2, light from the light source 61 irradiates the field stop 64 through the condenser lens 63. Portions of the light having reached the field stop 64, which have reached the main aperture SL0 or secondary apertures SL1, SL2 pass through the field stop, and other portions are stopped. The portions having passed through the field stop 64 reaches the beam splitter 68 through the illumination relay lens 66, whose one part is reflected downwards in the drawing and whose other part passes through the beam splitter 68. It is remarked that, because the alignment microscope AS uses only the light reflected by the beam splitter 68 in viewing marks and focusing as described later, a description will be presented in the following focusing on the light reflected by the beam splitter 68.

The light reflected by the beam splitter 68 advances through the first objective lens 69 and irradiates the surface of the wafer W to form the image of the field stop 64 on an expected focus plane (not shown) conjugate to the field stop 64 with respect to an imaging optical system composed of the illumination relay lens 66, the beam splitter 68, and the first objective lens 69. As a result, when the surface of the wafer W substantially coincides with the expected focus plane, areas on the surface of the wafer W are irradiated which are conjugate to and have the same shapes and sizes as the main aperture SL0 and secondary apertures SL1, SL2 respectively.

The first imaging optical system 70 comprises the first objective lens 69, the beam splitter 68, a second objective lens 71 and a beam splitter 72, which are arranged in that order in the Z-direction (vertically).

Light from the light source 61 irradiates the wafer W through the illumination optical system 62, is reflected by the surface of the wafer W, and, through the first objective lens 69, reaches the beam splitter 68. Part of the light having reached the beam splitter 68 is reflected toward the right in the drawing, and the other passes through the beam splitter 68. It is remarked that, because the alignment microscope AS uses only the light, at this stage, passing through the beam splitter 68 in viewing marks and focusing as described later, a description will be presented in the following focusing on the light passing through the beam splitter 68.

The light having passed through the beam splitter 68 and advancing in the +Z direction reaches the beam splitter 72 through the second objective lens 71, and part thereof is reflected by the beam splitter 72 toward the left in the drawing while the other passes through the beam splitter 72. The light reflected by the beam splitter 72 forms images of the illuminated areas on the wafer W's surface on the light-receiving face of a later-described pick-up device 74 conjugate to the expected focus plane with respect to the first imaging optical system 70. Meanwhile, the light having passed through the beam splitter 72 forms images of the illuminated areas on the wafer W's surface on a later-described shading plate 75 conjugate to the expected focus plane with respect to the first imaging optical system 70.

The pick-up device 74 has a charge coupled device (CCD) and a light receiving face substantially parallel to the X-Z plane that has such a shape as it receives only light reflected by the illumination area on the wafer W corresponding to the main aperture SL0 of the field stop 64, and picks up the image of the illumination area on the wafer W corresponding to the main aperture SL0 with supplying the picking-up result as first pick-up data IMD1 to the main control system 20.

The shading plate 75, as shown in Fig. 3B, has slit-like apertures SLL, SLR that are separate in the Y-direction from each other and that transmits only light reflected by the illumination areas on the wafer W corresponding to the secondary apertures SL1, SL2 on the field stop 64 respectively. Therefore, of light having reached the shading plate 75 through the first imaging optical system 70 two beam portions reflected by the illumination areas on the wafer W corresponding to the secondary apertures SL1, SL2 pass through the shading plate 75 and advance in the +Z direction.

The second imaging optical system 76 comprises a first relay lens 77, a pupil-dividing, reflective member 78, a second relay lens 79, and a cylindrical lens 80. The pupil-dividing, reflective member 78 is a prism-like optical member that has two surfaces finished to be reflective, which are perpendicular to the Y-Z plane and make an obtuse angle with each other close to 180 degrees. It is remarked that instead of the pupil-dividing, reflective member 78 a pupil-dividing, transmissible member may be used. Furthermore, the cylindrical lens 80 is disposed such that its axis is substantially parallel to the Z-axis.

The two beam portions having passed through the shading plate 75 and advancing in the +Z direction reaches the pupil-dividing, reflective member 78 through the first relay lens 77, and both are made incident on the two reflective surface of the pupil-dividing, reflective member 78. As a result, each of the two beam portions having passed through the slit-like apertures SLL, SLR of the shading plate 75 are divided by the pupil-dividing, reflective member 78 into two light beams, and the four light beams advance toward the right in the drawing, which, after passing through the second relay lens 79 and cylindrical lens 80, image the apertures SLL, SLR on the light-receiving face of the pick-up device 81 conjugate to the shading plate 75 with respect to the second imaging optical system. That is, the two light beams from the light having passed through the aperture SLL each form an image corresponding to the aperture SLL, and the two light beams from the light having passed through the aperture SLR each form an image corresponding to the aperture SLR.

The pick-up device 81 has a charge coupled device (CCD) and a light receiving face substantially parallel to the X-Z plane and picks up the images corresponding to the apertures SLL, SLR formed on the light receiving face with supplying the picking-up result as second pick-up data IMD2 to the stage control system 19.

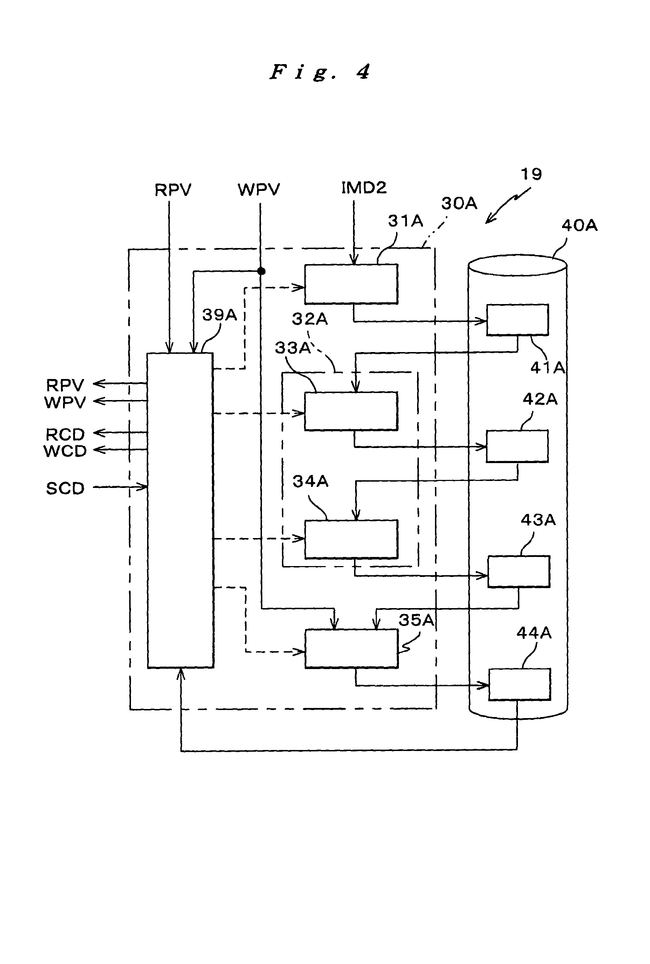

The stage control system 19, as shown in Fig. 4, comprises a stage controller 30A and a storage unit 40A.

The stage controller 30A comprises (a) a controller 39A that supplies to the main control system 20 the position information RPV, WPV from the reticle interferometer 16 and the wafer interferometer 18 according to stage control data SCD from the main control system 20 and that adjusts the positions and yaws of the reticle R and the wafer W by outputting reticle stage control signal RCD and wafer stage control signal WCD based on the position information RPV, WPV, (b) a pick-up data collecting unit 31A for collecting second pick-up data IMD2 from the alignment microscope AS, (c) a coincidence-degree calculating unit 32A for calculating the degree of coincidence between two areas while moving the two areas in the pick-up area based on the second pick-up data IMD2 collected, and (d) a Z-position information calculating unit 35A for obtaining defocus amount (error in the Z-direction from the focus position) of the wafer W based on the calculated degree of coincidence between the two areas. Here, the coincidence-degree calculating unit 32A comprises (i) a coordinate transforming unit 33A for transforming the picking-up result for one area by the use of a coordinate transforming method corresponding to the identity between the one area and the other area, between which the degree of coincidence is calculated, and (ii) a calculation processing unit 34A for calculating the degree of coincidence between the two areas based on the coordinate-transformed, picking-up result for the one area and the picking-up result for the other area.

The storage unit 40A has a pick-up data store area 41A, a coordinate-transformed result store area 42A, a degree-of-inter-area-coincidence store area 43A, and a defocus-amount store area 44A therein.

Incidentally, while, in this embodiment, the stage controller 30A comprises the various units as described above, the stage controller 30A may be a computer system where the functions of the various units are implemented as program modules installed therein.

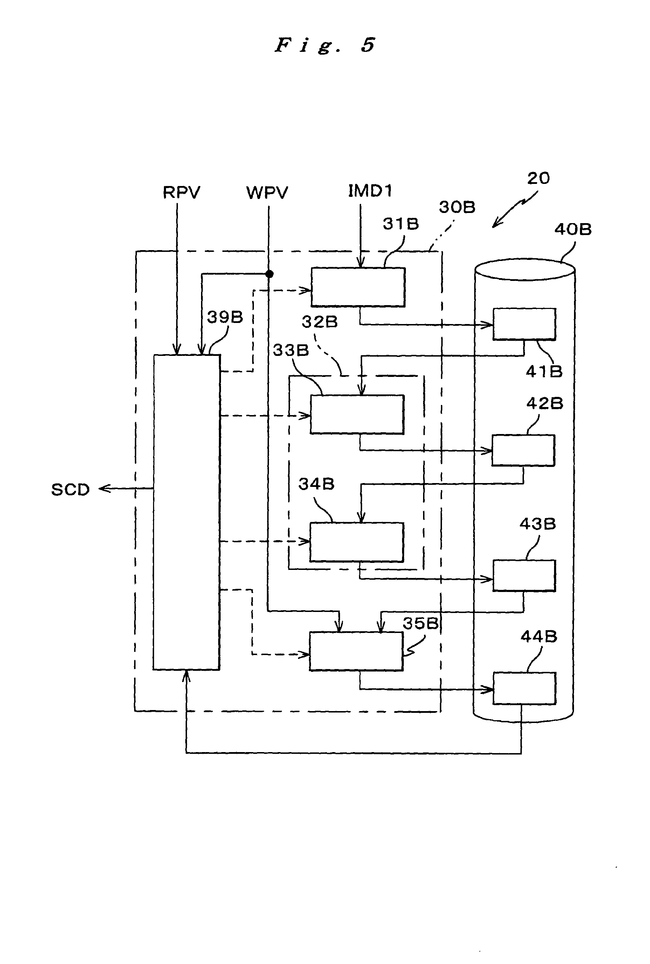

The main control system 20, as shown in Fig. 5, comprises a main controller 30B and a storage unit 40B.

The main controller 30B comprises (a) a controller 39B for controlling the exposure apparatus 100 by, among other things, supplying stage control data SCD to the stage control system 19, (b) a pick-up data collecting unit 31B for collecting first pick-up data IMD1 from the alignment microscope AS, (c) a coincidence-degree calculating unit 32B for calculating the degrees of coincidence between three areas while moving the three areas in the pick-up area based on the first pick-up data IMD1 collected, and (d) a mark position information calculating unit 35B for obtaining the X-Y position of a position-detection mark on the wafer W based on the calculated degrees of coincidence between the three areas. Here, the coincidence-degree calculating unit 32B comprises (i) a coordinate transforming unit 33B for transforming the picking-up result for one area by the use of a coordinate transforming method corresponding to the symmetry between the one area and another area, between which the degree of coincidence is calculated, and (ii) a calculation processing unit 34B for calculating the degree of coincidence between the two areas based on the coordinate-transformed, picking-up result for the one area and the picking-up result for the other area.

The storage unit 40B has a pick-up data store area 41B, a coordinate-transformed result store area 42B, a degree-of-inter-area-coincidence store area 43B, and a mark-position store area 44B therein.

Incidentally, while, in this embodiment, the main controller 30B comprises the various units as described above, the main controller 30B may be a computer system where the functions of the various units are implemented as program modules installed therein as in the case of the stage control system 19.

Furthermore, when the main control system 20 and stage control system 19 are computer systems, all program modules for accomplishing the functions, described later, of the various units of the main controllers 30A, 30B need not be installed in advance therein.

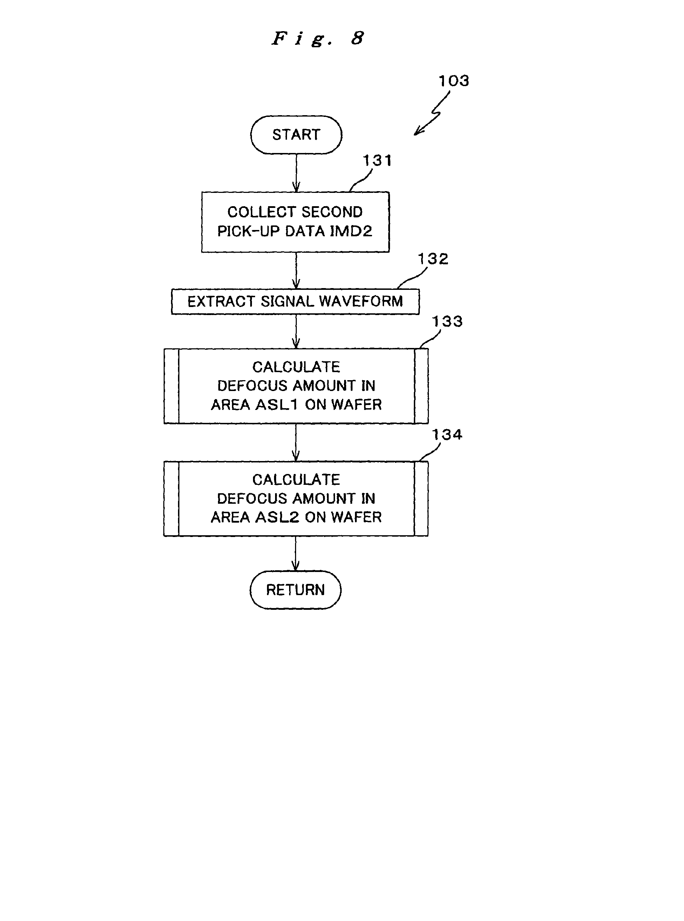

For example, as indicated by a dashed line in Fig. 1, the main control system 20 may be constructed such that a reader 90a is attachable thereto to which a storage medium 91a is attachable and which can read program modules from the storage medium 91a storing necessary program modules, in which case the main control system 20 reads program modules (e.g. subroutines shown in Figs. 8, 12, 16, 23) necessary to accomplish functions from the storage medium 91a loaded into the reader 90a and executes the program modules.

Moreover, the stage control system 19 may be constructed such that a reader 90b is attachable thereto to which a storage medium 91b is attachable and which can read program modules from the storage medium 91b storing necessary program modules, in which case the stage control system 19 reads program modules necessary to accomplish functions from the storage medium 91b loaded into the reader 90b and executes the program modules.

Further, the main control system 20 and the stage control system 19 may be constructed so as to read program modules from the storage media 91a and 91b loaded into the readers 90a and 90b respectively and install them therein. Yet further, the main control system 20 and the stage control system 19 may be constructed so as to install program modules sent through a communication network such as the Internet and necessary to accomplish functions therein.

Incidentally, as the storage media 91a and 91b, magnetic media (magnetic disk, magnetic tape, etc.), electric media (PROM, RAM with battery backup, EEPROM, etc.), photo-magnetic media (photo-magnetic disk, etc.), electromagnetic media (digital audio tape (DAT), etc.) and the like can be used.

Further, one reader may be shared by the main control system 20 and the stage control system 19 and have its connection switched. Still further, the main control system 20, to which a reader is connected, may send program modules for the stage control system 19 read from the storage medium 91b to the stage control system 19. The method by which the connection is switched and the method by which the main control system 20 sends to the stage control system 19 can be applied to the case of installing program modules through a communication network as well.

Constructing, as described above, the main control system 20 and the stage control system 19 to be able to install program modules necessary to accomplish functions from storage media or through a communication network therein makes it easy to, later, change the program modules or replace them with a new version for improving capability.

Referring back to Fig. 1, fixed on a supporting portion (not shown) of the projection optical system PL in the exposure apparatus 100 is a multi-focus-position detection system of an oblique-incidence type comprising an illumination optical system and a light-receiving optical system (none are shown). The illumination optical system directs imaging light beams for forming a plurality of slit images on the best imaging plane of the projection optical system PL in an oblique direction to the optical axis AX, and the light-receiving optical system receives the light beams reflected by the surface of the wafer W through respective slits. And the stage control system 19 moves the wafer holder 25 in the Z-direction and tilts it based on position information of the wafer from the multi-focus-position detection system. The construction of such a multi-focal detection system is disclosed in detail in, for example, Japanese Patent Application Laid-Open No. 6-283403 and U.S. Patent No. 5,448,332 corresponding thereto. The disclosure in the above Japanese Patent Application Laid-Open and U.S. Patent is incorporated herein by reference as long as the national laws in designated states or elected states, to which this international application is applied, permit.

Next, the exposure operation for the second or later layer of the wafer W by the exposure apparatus 100 of this embodiment having the above structure will be described.

First, a reticle loader (not shown) loads a reticle R onto the reticle stage RST, and the main control system 20 performs reticle alignment and base-line measurement. Specifically, the main control system 20 positions the reference mark plate FM on the wafer stage WST underneath the projection optical system PL via the wafer-stage driving portion 24. After detecting relative position between the reticle alignment mark on the reticle R and the first reference mark on the reference mark plate FM by use of the reticle alignment system 22, the wafer stage WST is moved along the X-Y plane by a predetermined amount, e.g. a design value for base-line amount to detect the second reference mark on the reference mark plate FM by use of the alignment microscope AS. At the same time the main control system 20 obtains base-line amount based on the measured positional relation between the detection center of the alignment microscope AS and the second reference mark, the before-measured positional relation between the reticle alignment mark and the first reference mark on the reference mark plate FM, and measurement values of the wafer interferometer 18 corresponding to the foregoing two.

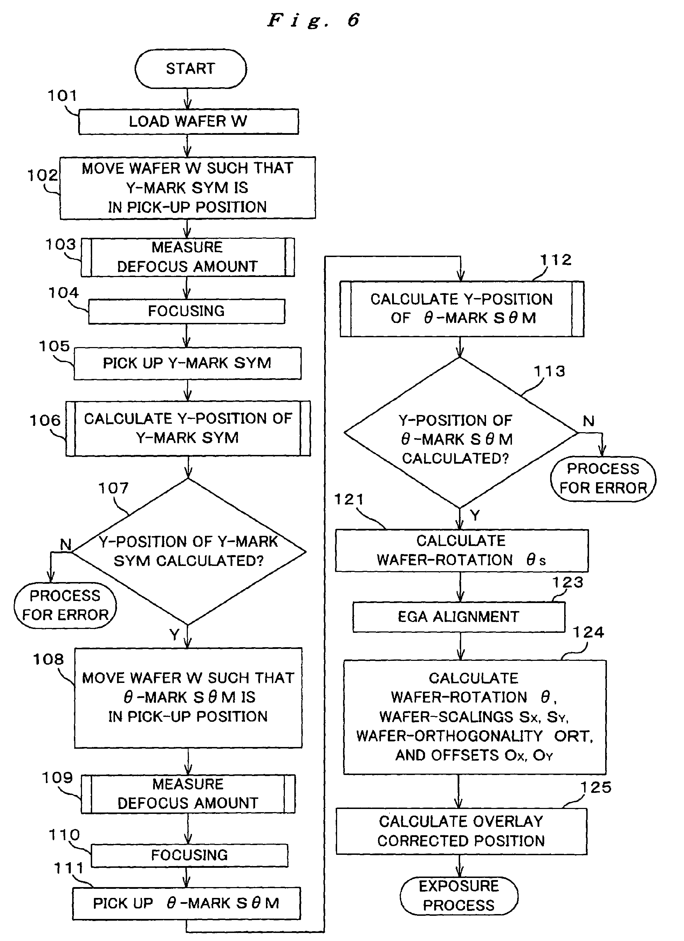

After the above preparation, the operation shown by the flow chart in Fig. 6 starts.

First, in a step 101, the main control system 20 instructs the control system of a wafer loader (not shown) to load a wafer W. By this, the wafer loader loads a wafer W onto the wafer holder 25 on the wafer stage WST.

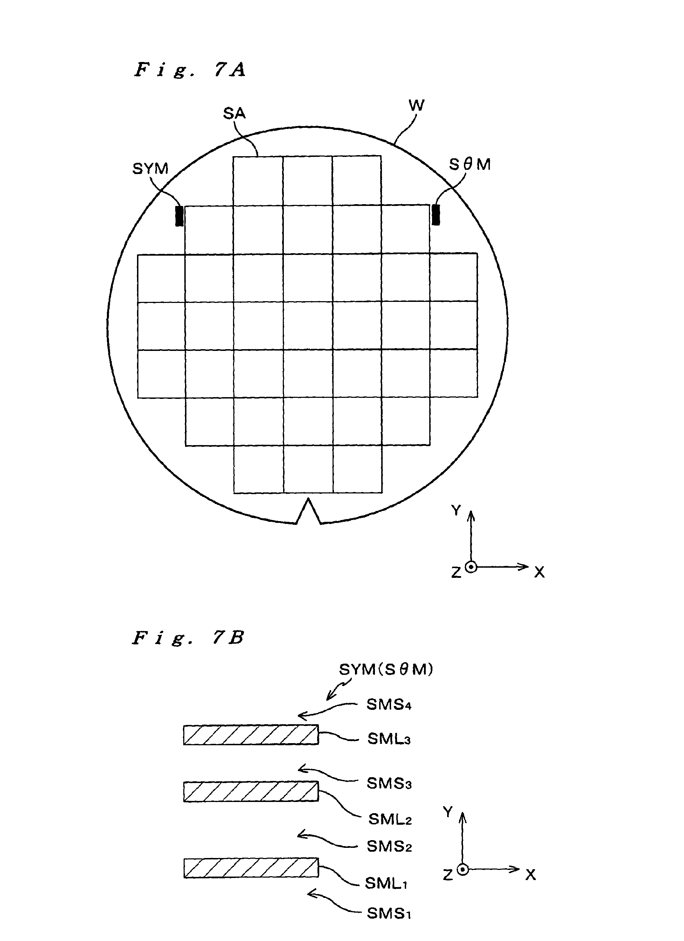

As a premise, it is assumed that search-alignment marks including a Y-mark SYM and a θ-mark SθM (see Fig. 7A) together with a reticle pattern are transferred and formed on the wafer W by exposure up to the prior layer. Although the search-alignment marks are in practice formed on each shot area SA shown in Fig. 7A, two search-alignment marks are, in this embodiment, considered which are, as shown in Fig. 7, so arranged that the distance in the X-direction between the two and the distance in the Y-direction from the wafer W's center are long in order to obtain the orientation and center position of the wafer W with detecting the positions of a minimum number of marks and which are a Y-mark SYM and a θ-mark SθM respectively.

Furthermore, in this embodiment the search-alignment mark, that is, the Y-mark SYM or θ-mark SθM, is a line-and-space mark as shown in Fig. 7B which has line-features $SML_1$, $SML_2$, $SML_3$ extending in the X-direction and spaces $SMS_1$, $SMS_2$, $SMS_3$, $SMS_4$, the lines and spaces being alternately arranged in the Y-direction. That is, a space $SMS_m$ is placed on the -Y direction side of a line-feature $SML_m$ (m=1 through 3) and a space $SMS_{m+1}$ is on the +Y direction side of the line-feature $SML_m$. It is remarked that while in this embodiment the line-and-space mark as the search-alignment mark has three lines, the number of lines may be other than three and that while in this embodiment the space widths are different from each other, the space widths may be the same.

Next, in a step 102, the main control system 20 moves the wafer stage WST and thus the wafer W via the stage control system 19 and wafer-stage driving portion 24 based on position information WPV of the wafer stage WST from the wafer interferometer 18 such that an area including the Y-mark SYM subject to position detection lies within the pick-up area of the pick-up device 74, for detecting mark positions, of the alignment microscope AS.

After the Y-mark SYM formed area is placed within the pick-up area of the pick-up device 74, defocus amount of the Y-mark SYM formed area is measured in a subroutine 103.

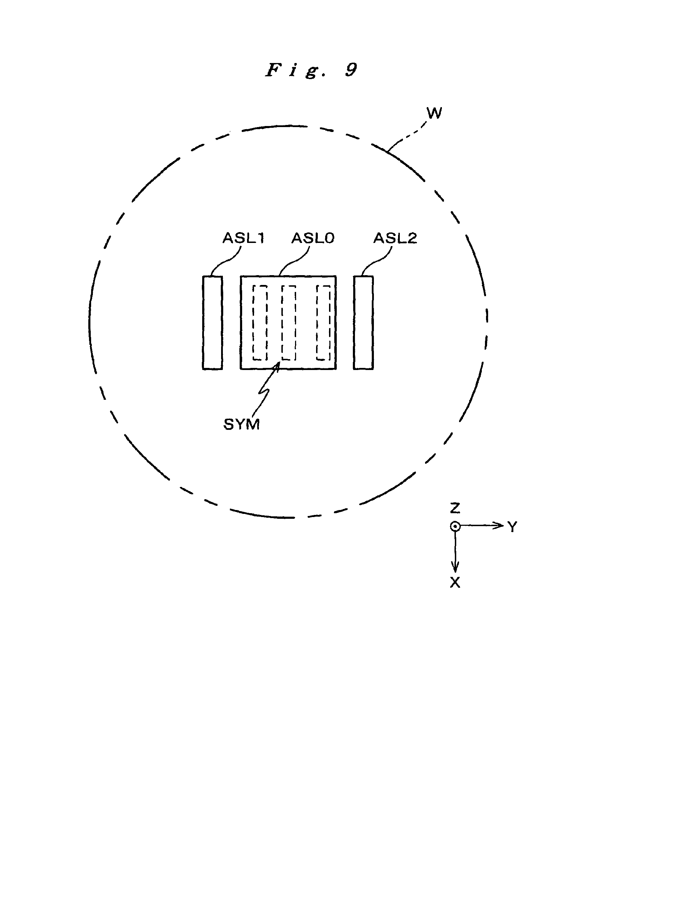

In the subroutine 103, first in a step 131, the stage control system 19 collects, as shown in Fig. 8, second pick-up data IMD2 under the control of the controller 39A by making the light source 61 of the alignment microscope AS emit light to illuminate areas ASL0, ASL1, ASL2 on the wafer W, as shown in Fig. 9, corresponding to the apertures SL0, SL1, SL2 of the field stop 64 in the alignment microscope AS respectively. Here, the Y-mark SYM lies within the area ASL0.

Light reflected by the areas ASL1, ASL2 on the wafer W passes sequentially through the first imaging optical system 70, the shading plate 75 and the second imaging optical system 76 in the alignment microscope AS, and is imaged on the light-receiving face of the pick-up device 81. Let XF and YF directions in the light-receiving face of the pick-up device 81 be conjugate to the X and Y directions in the wafer coordinate system respectively. The image formed is, as shown in Fig. 10A, composed of four slit images $ISL1_L$, $ISL1_R$, $ISL2_L$, $ISL2_R$ which are arranged in the YF-direction, the slit images $ISL1_L$, $ISL1_R$ being formed by two light beams into which the pupil-dividing, reflective member 78 has divided light reflected by the area ASL1 and having a width WF1 in the YF direction, the slit images $ISL2_L$, $ISL2_R$ being formed by two light beams into which the pupil-dividing, reflective member 78 has divided light reflected by the area ASL2 and having a width WF2 in the YF direction. In this embodiment, the widths WF1 and WF2 are the same.

Furthermore, the slit images $ISL1_L$ and $ISL1_R$ are symmetric with respect to an axis through a YF position $YF1_0$ and parallel to the XF-direction, and the distance DW1 (hereinafter, called an "image pitch DW1") between the centers thereof in the YF direction varies according to defocus amount of a corresponding illumination area on the wafer W. Also, the slit images $ISL2_L$ and $ISL2_R$ are symmetric with respect to an axis through a YF position $YF2_0$ and parallel to the XF-direction, and the distance DW2 (hereinafter, called an "image pitch DW2") between the centers thereof in the YF direction varies according to defocus amount of a corresponding illumination area on the wafer W. Therefore, the image pitches DW1 and DW2 are functions of defocus amount DF, which are indicated by image pitches DW1(DF) and DW2(DF), where the YF positions $YF1_0$, $YF2_0$ and the widths WF1, WF2 are assumed to be known.

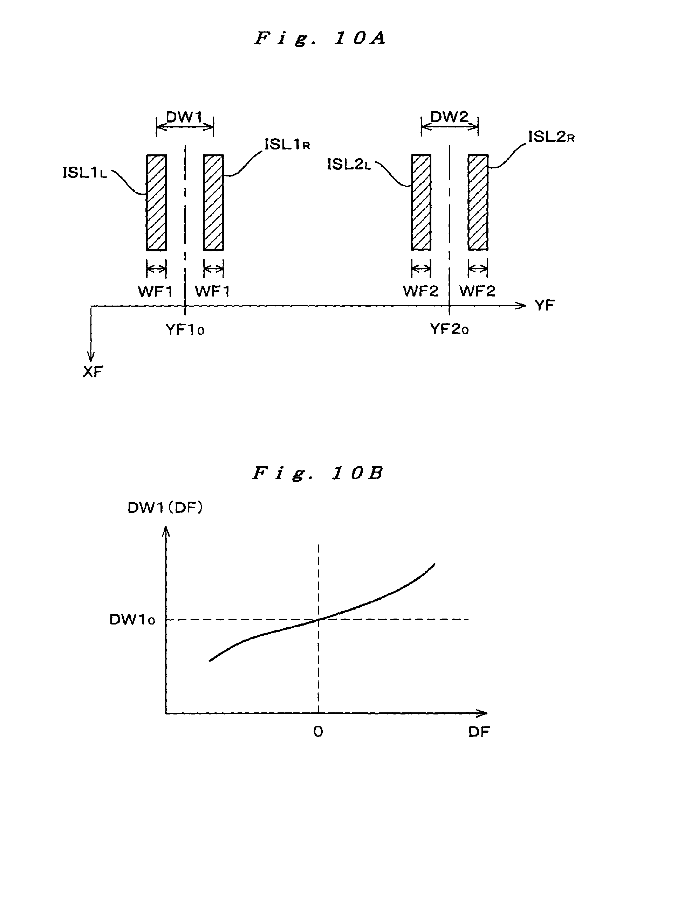

The relation between defocus amount DF and the image pitch DW1(DF), DW2(DF) is linear where defocus amount DF is close or equal to zero, as shown representatively by the relation between defocus amount DF and the image pitches DW1(DF) in Fig. 10B and is assumed to be known by, e.g., measurement in advance. In Fig. 10B, image pitch DW1(0) that denotes one when the image is focused is indicated by $DW1_0$.

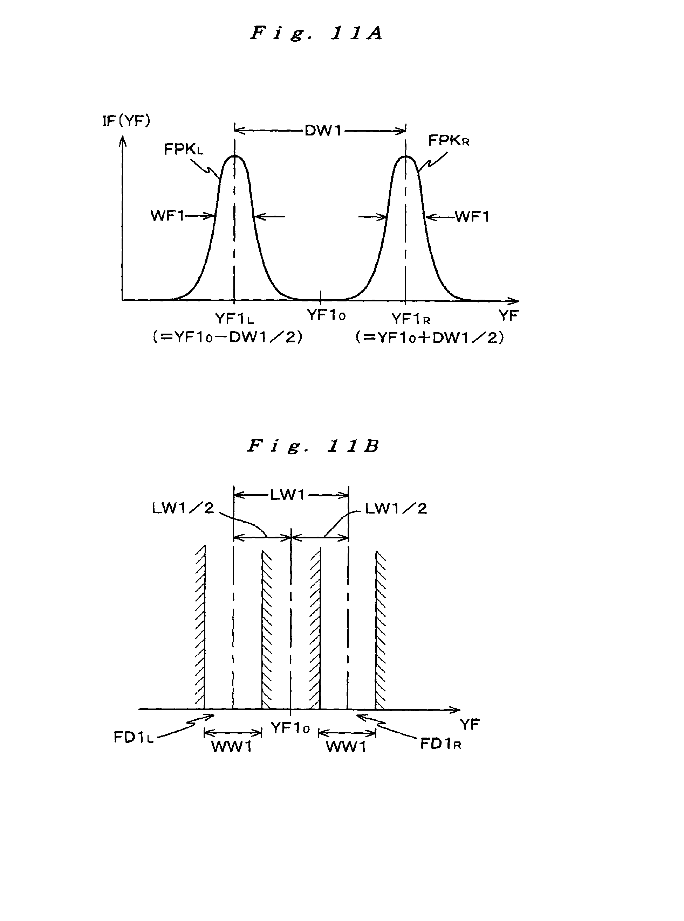

Referring back to Fig. 8, in a step 132 the coordinate transforming unit 33A of the coincidence-degree calculating unit 32A reads pick-up data from the pick-up data store area 41A, and a signal waveform IF(YF) that represents an average signal intensity distribution in the YF direction is obtained by averaging light intensities on a plurality of (e. g. 50) scan lines extending in the YF direction near the centers in the XF direction of the slit images $ISL1_L$, $ISL1_R$, $ISL2_L$, $ISL2_R$ in order to cancel white noise. Fig. 11A shows an example of part of the signal waveform IF(YF) around and at the slit images $ISL1_L$, $ISL1_R$.

As shown in Fig. 11A, the signal waveform IF(YF) has two peaks $FPK_L$, $FPK_R$ corresponding to the slit images $ISL1_L$, $ISL1_R$ and a shape symmetric with respect to the YF position $YF1_0$, the peak $FPK_L$ being symmetric with respect to the vertical line through the center position $YF1_L$ ($=YF1_0-DW1/2$) of the peak, the peak $FPK_R$ being symmetric with respect to the vertical line through the center position $YF1_R$ ($=YF1_0+DW1/2$) of the peak. That is, the peaks $FPK_L$ and $FPK_R$ are substantially the same in shape with having translational identity, and the pitch between them has the value ($YF1_R -YF1_L$).

Referring back to Fig. 8, in a subroutine 133 defocus amount DF1 of the area ASL1 on the wafer W is detected.

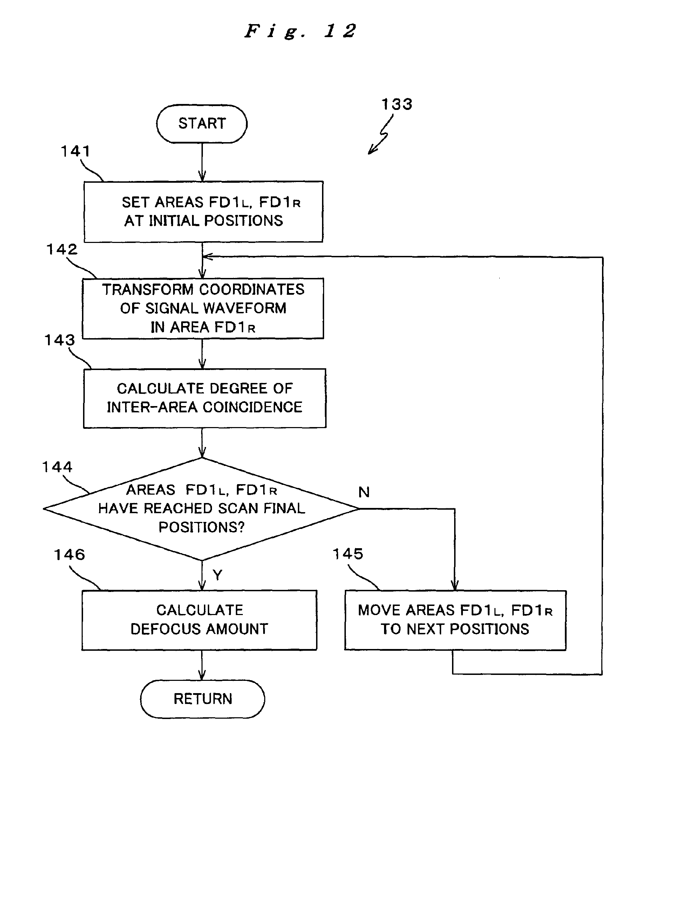

In a step 141 of the subroutine 133 shown in Fig. 12, the coordinate transforming unit 33A defines two one-dimensional areas $FD1_L$ and $FD1_R$ along the YF direction, as shown in Fig. 11B, which are symmetric with respect to the YF position $YF1_0$ and each have a width WW1 ($\geq$ WF1), and a distance LW1 between the centers of the areas $FD1_L$ and $FD1_R$ is variable, which is called a "area pitch LW1" hereinafter.

Subsequently, the coordinate transforming unit 33A determines initial and final positions in scan of the areas $FD1_L$ and $FD1_R$ and sets the areas $FD1_L$ and $FD1_R$ at the initial positions. Here, the initial value of the area pitch LW1 can be zero, but preferably is set to be slightly smaller than the minimum in the value range of the image pitch DW1 which range corresponds to the value range of defocus amount DF predicted from design before actual measurement in terms of quickly measuring defocus amount DF. Further, the final value of the area pitch LW1 can be large enough, but preferably is set to be slightly larger than the maximum in the value range of the image pitch DW1 which range corresponds to the value range of defocus amount DF predicted from design before actual measurement in terms of quickly measuring defocus amount DF.

Next, the principle of detecting defocus amount DF1 of the area ASL1 on the wafer W in steps 142 and later will be briefly described.

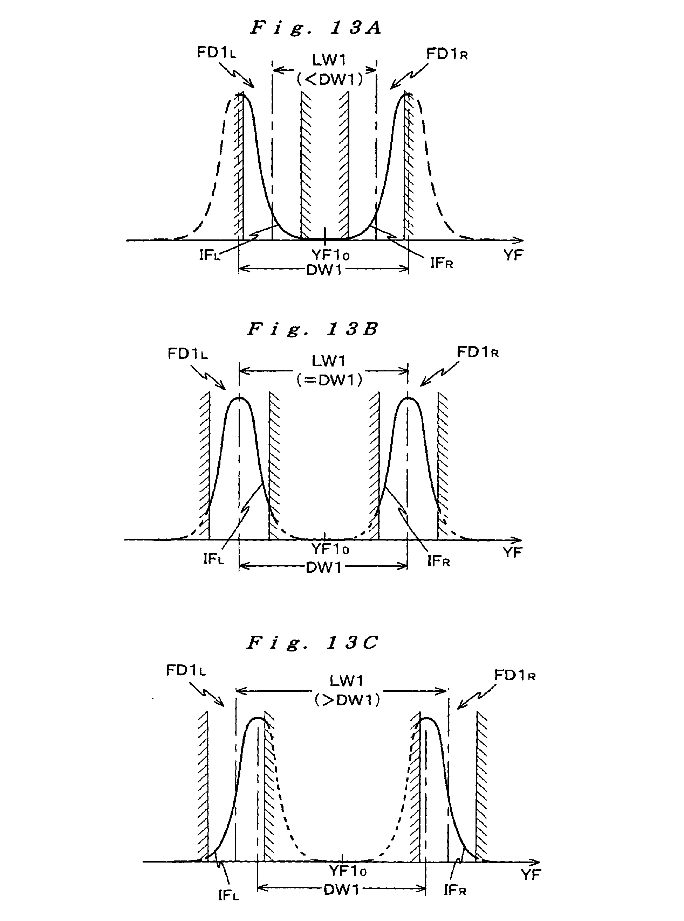

First in the detection of defocus amount DF1 in this embodiment, the image pitch DW1 is detected by making the one-dimensional areas $FD1_L$ and $FD1_R$ scan from the initial position through the final position with maintaining the symmetry between the areas $FD1_L$ and $FD1_R$ with respect to the YF position $YF1_0$ (see Figs. 13A to 13C). The reason why the one-dimensional areas $FD1_L$ and $FD1_R$ are made to scan with maintaining the symmetry with respect to the YF position $YF1_0$ is that, at a point of time in the scan, the area pitch LW1 coincides with the image pitch DW1 (see Fig. 13B), when signal waveforms $IF_L(YF)$ and $IF_R(YF)$ in the areas $FD1_L$ and $FD1_R$ reflect the translational identity and symmetry with respect to the YF position $YF1_0$ between the peaks $FPK_L$ and $FPK_R$ in the signal waveform IF(YF) and the symmetry in the shape of each peak.

During the scan, as shown in Figs. 13A to 13C, the signal waveforms $IF_L(YF)$ and $IF_R(YF)$ vary while the symmetry between the signal waveforms $IF_L(YF)$ and $IF_R(YF)$ is always maintained. Therefore, it cannot be told by detecting the symmetry between the signal waveforms $IF_L(YF)$ and $IF_R(YF)$ whether or not the area pitch LW1 coincides with the image pitch DW1 (shown in Fig. 13B).

Meanwhile, the translational identity between the signal waveforms $IF_L(YF)$ and $IF_R(YF)$ is best when the area pitch LW1 coincides with the image pitch DW1. Also the symmetry of each of the signal waveforms $IF_L(YF)$ and $IF_R$ (YF) is best when the area pitch LW1 coincides with the image pitch DW1. However, as mentioned above, the symmetry between the signal waveforms $IF_L(YF)$ and $IF_R(YF)$ is good whether or not the area pitch LW1 coincides with the image pitch DW1.

Therefore, in this embodiment, the image pitch DW1 is detected by examining the translational identity between the signal waveforms $IF_L(YF)$ and $IF_R(YF)$ with making the areas $FD1_L$ and $FD1_R$ scan, and the defocus amount DF1 is detected based on the image pitch DW1.

The image pitch DW1 and the defocus amount DF1 are detected specifically in the following manner.

In a step 142 subsequent to the step 141 of Fig. 12, the coordinate transforming unit 33A extracts from the signal waveform IF(YF) the signal waveforms $IF_L(YF)$ and $IF_R(YF)$ in the areas $FD1_L$ and $FD1_R$. Here, the signal waveform $IF_L(YF)$ is given by the following equations:

$$IF_L(YF)=IF(YF; YF_{LL}\leq YF \leq YF_{LR}) \qquad (1)$$

$$YF_{LL}=YF1_0-LW1/2-WW1/2 \tag{2}$$

$$YF_{LR}=YF1_0-LW1/2+WW1/2, \tag{3}$$

and the signal waveform $IF_R(YF)$ is given by the following equations:

$$IF_R(YF)=IF(YF; YF_{RL}\leq YF \leq YF_{RR}) \tag{4}$$

$$YF_{RL}=YF1_0+LW1/2-WW1/2 \tag{5}$$

$$YF_{RR}=YF1_0+LW1/2+WW1/2. \tag{6}$$

And the coordinate transforming unit 33A transforms the coordinate of the signal waveform $IF_R(YF)$ by translating the coordinate system in the +YF direction by the distance LW1 to obtain a transformed signal waveform $TIF_R(YF')$ given by the following equation

$$TIF_R(YF')=IF_R(YF), \tag{7}$$

where YF'=YF-LW1. As a result, the signal waveforms $TIF_R(YF')$ and $IF_L(YF)$ can be directly compared because the ranges thereof in the respective horizontal coordinates are the same.

Then the coordinate transforming unit 33A stores the obtained signal waveforms $IF_L(YF)$ and $TIF_R(YF')$ in the coordinate-transformed result store area 42A.

Next, in a step 143, the calculation processing unit 34A reads the signal waveforms $IF_L(YF)$ and $TIF_R(YF')$ from the coordinate-transformed result store area 42A, calculates a normalized correlation NCF1(LW1) between the signal waveforms $IF_L(YF)$ and $TIF_R(YF')$ which represents the degree of coincidence between the signal waveforms $IF_L(YF)$ and $TIF_R(YF')$ in the respective areas $FD1_L$ and $FD1_R$, and stores the normalized correlation NCF1(LW1) as the degree of inter-area coincidence together with the area pitch LW1's value in the coincidence-degree store area 43A.

Next, in a step 144, it is checked whether or not the areas $FD1_L$ and $FD1_R$ have reached the final positions. At this stage because only for the initial positions the degree of inter-area coincidence has been calculated, the answer is NO, and then the process proceeds to a step 145.

In the step 145, the coordinate transforming unit 33A replaces the area pitch LW1 with a new area pitch (LW1+ΔL), where ΔL indicates a unit pitch corresponding to desired resolution in measurement of a defocus amount, and moves the areas $FD1_L$ and $FD1_R$ according to the new area pitch LW1. And the coordinate transforming unit 33A executes the steps 142, 143, in the same way as for the initial positions, to calculate a coincidence-degree NCF1(LW1) and store it together with the current area pitch LW1's value in the coincidence-degree store area 43A.

Until the answer in the step 144 is YES, in the same way as described above, each time it increases the area pitch LW1 by the unit pitch ΔL in the step 145, the coordinate transforming unit 33A executes the steps 142, 143 to calculate a coincidence-degree NCF1(LW1) and store it together with the current area pitch LW1's value in the coincidence-degree store area 43A. Figs. 13A to 13C illustrate an example of the relations during the scan between the scan positions of the areas $FD1_L$ and $FD1_R$ and the signal waveform IF(YF). It is understood that Fig. 13A shows the case where the area pitch LW1 is smaller than the image pitch DW1 (LW1<DW1), that Fig. 13B shows the case where the area pitch LW1 is equal to the image pitch DW1 (LW1=DW1), and that Fig. 13C shows the case where the area pitch LW1 is larger than the image pitch DW1 (LW1>DW1).

Referring back to Fig. 12, when the areas $FD1_L$ and $FD1_R$ have reached the final positions, the answer in the step 144 is YES, and the process proceeds to a step 146.

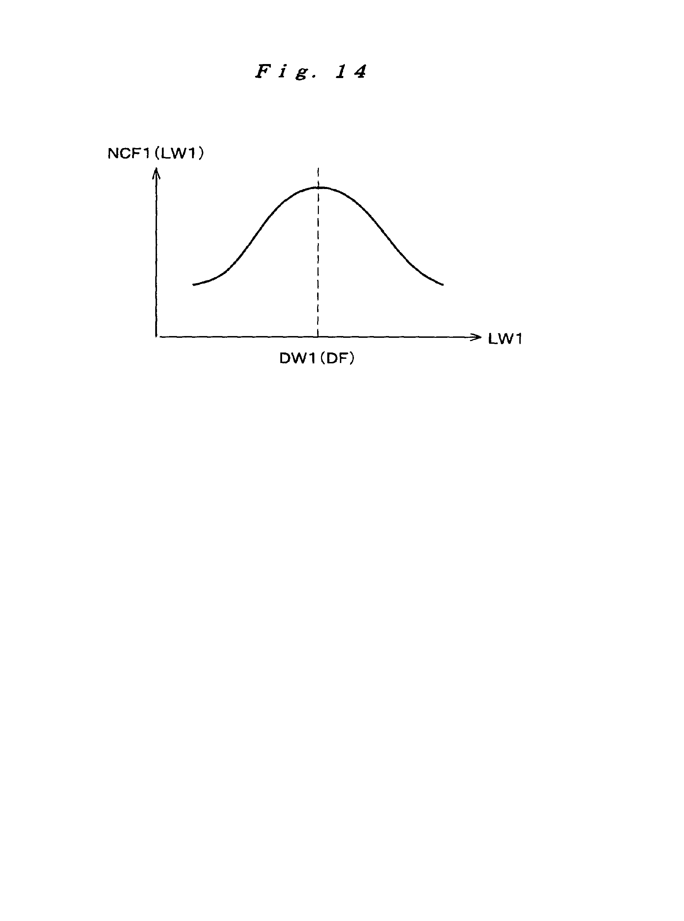

In the step 146, the Z-position information calculating unit 35A reads the coincidence-degrees NCF1(LW1) and the corresponding area pitch LW1's values from the coincidence-degree store area 43A and examines the relation of the coincidence-degree NCF1(LW1) to the varying area pitch LW1, whose example is shown in Fig. 14. In Fig. 14 the coincidence-degree NCF1(LW1) takes on a maximum when the area pitch LW1 coincides with the image pitch DW1. Therefore, the Z-position information calculating unit 35A sets the area pitch LW1's value as the image pitch DW1 at which value the coincidence-degree NCF1(LW1) takes on a maximum in the relation to the varying area pitch LW1.

Subsequently, the Z-position information calculating unit 35A obtains defocus amount $DF_1$ of the area ASL1 on the wafer W based on the image pitch DW1 detected and the relation in Fig. 10B between defocus amount DF and the image pitch DW1(DF) and stores the defocus amount $DF_1$ in the defocus-amount store area 44A.

Referring back to Fig. 12, after the calculation of the defocus amount $DF_1$ in the area ASL1 on the wafer W is completed, the execution of the subroutine 133 ends, and the process proceeds to a subroutine 134 in Fig. 8.

In the subroutine 134, defocus amount $DF_2$ in the area ASL2 on the wafer W is, in the same way as for the defocus amount $DF_1$ in the area ASL1 in the subroutine 133, calculated and stored in the defocus-amount store area 44A.

When the calculation of the defocus amounts $DF_1$ and $DF_2$ is completed, the execution of the subroutine 103 ends. The process proceeds to a step 104 in the main routine of Fig. 6.

In the step 104, the controller 39A reads the defocus amounts $DF_1$ and $DF_2$ from the defocus-amount store area 44A and based on the defocus amounts $DF_1$, $DF_2$, obtains movement amount in the Z-direction and rotation amount about the X-axis of the wafer W with which to come to focus on the area ASL0 on the wafer W, and supplies wafer-stage control signal WCD containing the movement amount in the Z-direction and the rotation amount about the X-axis to the wafer-stage driving portion 24, whereby the position and yaw of the wafer W is controlled so as to focus on the area ASL0 on the wafer W.

After the completion of focusing on the area ASL0 including the Y-mark-SYM-formed area, the pick-up device 74 of the alignment microscope AS, in a step 105, picks up the image of the area ASL0 on the light-receiving face thereof under the control of the controller 39B, and the pick-up data collecting unit 31B stores first pick-up data IMD1 from the alignment microscope AS in the pick-up data store area 41B.

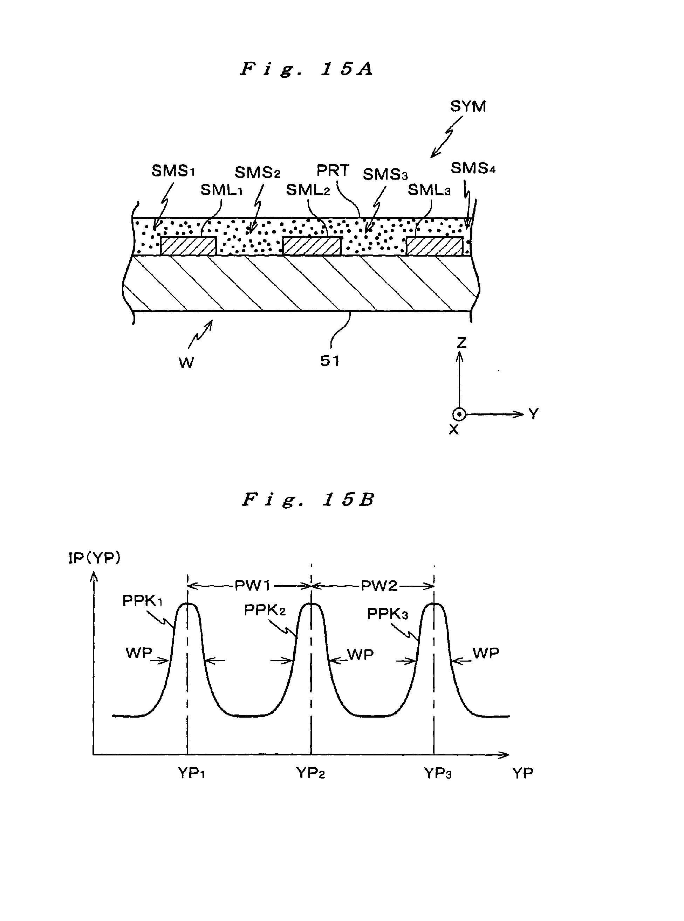

It is noted that, in the areas where the Y-mark SYM or θ-mark SθM is formed, as representatively shown by a YZ cross section of the Y-mark SYM in Fig. 15A, a resist layer PRT covers the line-features $SML_m$ (m=1 through 3) formed on a substrate 51 and the spaces $SMS_n$ (n=1 through 4), the upper portion of which layer is flattened by a flattening process, e.g. CMP. The resist layer PRT is made of a positive resist material or chemically amplified resist which has high light transmittance. The substrate 51 and the line-feature $SML_m$ are made of different materials from each other, which are usually different in reflectance and transmittance. In this embodiment, the material of the line-features $SML_m$ is higher in reflectance than that of the substrate 51. Furthermore, the upper surfaces of the substrate 51 and the line-features $SML_m$ are supposed to be substantially flat, and the height of the line-features $SML_m$ is supposed to be made small enough.

Referring back to Fig. 6, in a subroutine 106 the Y-position of the mark SYM is calculated from a signal waveform contained in the first pick-up data IMD1 in the pick-up data store area 41B.

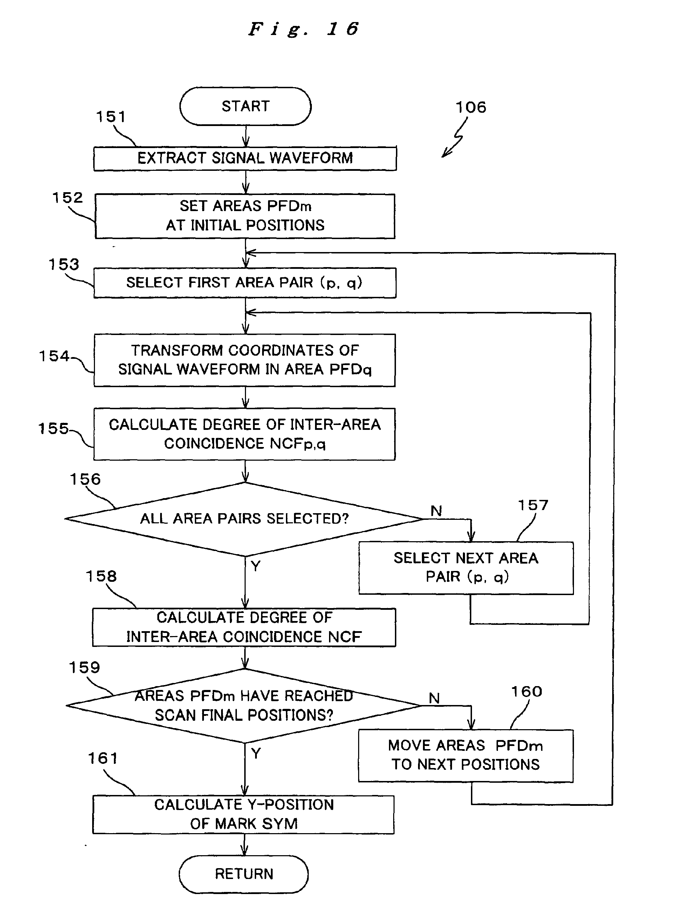

First, in a step 151 of the subroutine 106 as shown in Fig. 16, the coordinate transforming unit 33B of the coincidence-degree calculating unit 32B reads the first pick-up data IMD1 from the pick-up data store area 41B and extracts a signal waveform IP(YP). It is noted that XP and YP directions in the light receiving face of the pick-up device 74 are conjugate to the X- and Y-directions in the wafer coordinate system respectively.

The signal waveform IP(YP) that represents an average signal intensity distribution in the YP direction is obtained by averaging light intensities on a plurality of (e.g. 50) scan lines extending in the YP direction near the centers in the XP direction of the pick-up area in order to cancel white noise and then is smoothed in this embodiment. Fig. 15B shows an example of the signal waveform IP(YP) obtained.

As shown in Fig. 15B, the signal waveform IP(YP) has three peaks $PPK_m$ corresponding to the respective line-features $SML_m$ (m=1 through 3), which peaks have the same peak width WP. PW1 indicates the distance between the center position $YP_1$ in the YP direction of the peak $PPK_1$ and the center position $YP_2$ of the peak $PPK_2$, and PW2 indicates the distance between the center position $YP_2$ of the peak $PPK_2$ and the center position $YP_3$ of the peak $PPK_3$. Further, each peak $PPK_m$ has a shape symmetric with respect to the center position $YP_m$. Therefore, there is a translational identity with the distance PW1 in the YP direction between the shapes of the peaks $PPK_1$ and $PPK_2$, and there is a translational identity with the distance PW2 in the YP direction between the shapes of the peaks $PPK_2$ and $PPK_3$, and there is a translational identity with the distance (PW1+PW2) in the YP direction between the shapes of the peaks $PPK_1$ and $PPK_3$. Yet further, the peaks $PPK_1$, $PPK_2$, $PPK_3$ have a shape symmetric with respect to the center positions $YP_1$, $YP_2$, $YP_3$ respectively. Still further, the shape of the peaks $PPK_1$, $PPK_2$ as a whole is symmetric with respect to the middle position between the positions $YP_1$, $YP_2$, and the shape of the peaks $PPK_2$, $PPK_3$ as a whole is symmetric with respect to the middle position between the positions $YP_2$, $YP_3$, and the shape of the peaks $PPK_1$, $PPK_3$ as a whole is symmetric with respect to the middle position between the positions $YP_1$, $YP_3$.

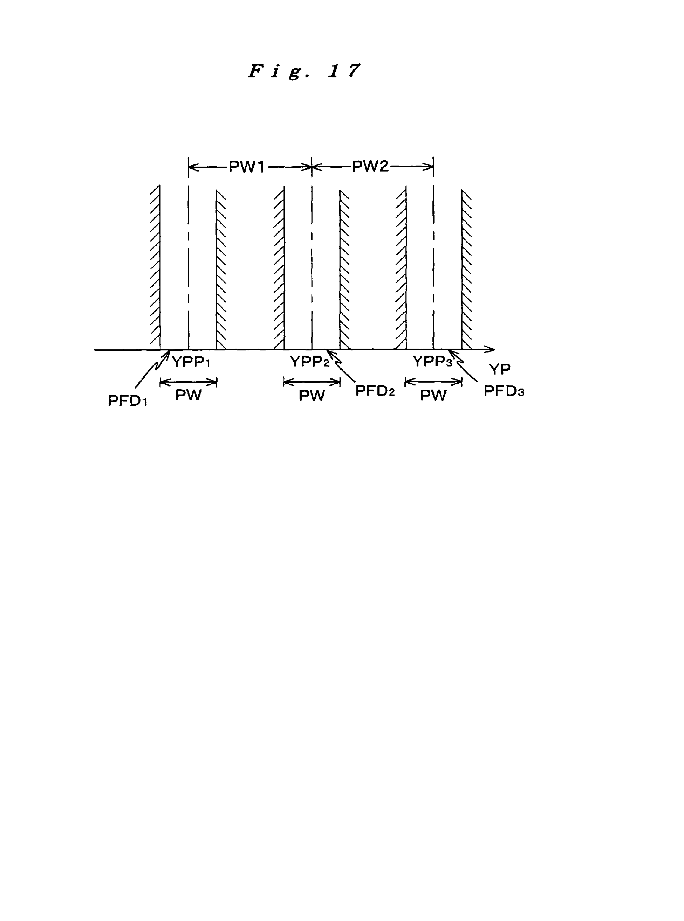

Referring back to Fig. 6, next in a step 152, the coordinate transforming unit 33A defines three one-dimensional areas $PFD_1$, $PFD_2$, $PFD_3$ which are arranged in that order in Fig. 17 and which have the same width PW (>WP) in the YP direction. In this embodiment the center position $YPP_1$ in the YP direction of the area $PFD_1$ is variable while, in another embodiment, the center position $YPP_2$ of the area $PFD_2$ or the center position $YPP_3$ of the area $PFD_3$ may be variable. The distance between the center position $YPP_1$ of the area $PFD_1$ and the center position $YPP_2$ of the area

$PFD_2$ is set to PW1, and the distance between the center position $YPP_2$ of the area $PFD_2$ and the center position $YPP_3$ of the area $PFD_3$ is set to PW2.

Subsequently, the coordinate transforming unit 33B determines initial and final positions for the scan of the areas $PFD_m$ and sets the areas $PFD_m$ at the initial positions. Here the initial value of the center position $YPP_1$ can be sufficiently small, but preferably is set to be slightly smaller than the minimum in the value range of the center position $YP_1$ of the peak $PPK_1$ which range is predicted from design before actual measurement in terms of quickly measuring the Y-position of the mark SYM. Further, the final value of the center position $YPP_1$ can be large enough, but preferably is set to be slightly larger than the maximum in the value range of the center position $YP_1$ of the peak $PPK_1$ which range is predicted from design before actual measurement in terms of quickly measuring the Y-position of the mark SYM.

Next, the principle of detecting the Y-position YY of the mark SYM on the wafer W in steps 153 and later will be briefly described.

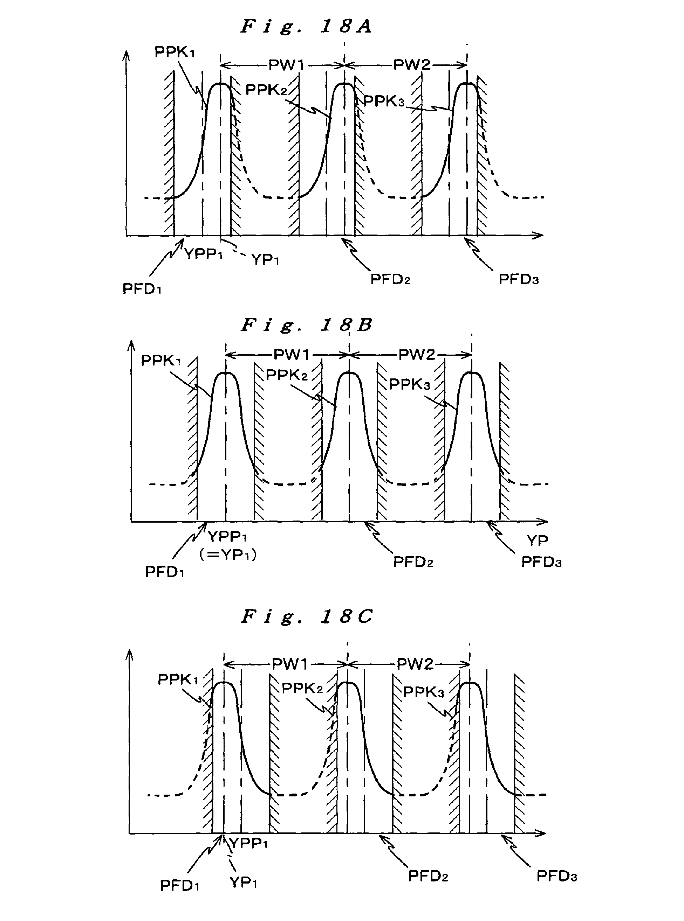

First in the detection of the Y-position YY in this embodiment, the center position $YP_1$ in the YP direction of the peak $PPK_1$ in the signal waveform IP(YP) is detected by making the areas $PFD_m$ scan from the initial position through the final position with maintaining the distances between the areas $PFD_m$ (see Figs. 18A to 18C). The reason why the areas $PFD_m$ are scanned with maintaining the distances between them is that, at a point of time in the scan, the center positions $YPP_m$ of the areas $PFD_m$ coincide with the center positions $YP_m$ of the peaks $PPK_m$ respectively (see Fig. 18B), when signal waveforms $IP_m(YP)$ in the areas $PFD_m$ reflect the translational identity and symmetry between the peaks $PPK_m$ in the signal waveform IP(YP) and the symmetry in the shape of each peak.

During the scan, as shown in Figs. 18A to 18C, the signal waveforms $IP_m(YP)$ vary while the translational identity between the signal waveforms $IP_m(YP)$ is always maintained. Therefore, it cannot be told by detecting the translational identity between the signal waveforms $IP_m(YP)$ whether or not the center positions $YPP_m$ of the areas $PFD_m$ coincide with the center positions $YP_m$ of the peaks $PPK_m$ respectively (shown in Fig. 18B).

Meanwhile, the symmetry between the signal waveforms $IP_p(YP)$ and $IP_q(YP)$, where p is any of 1 through 3 and q is a number of 1 through 3 and different from p, with respect to the middle position $YP_{p,q}$ between the areas $PFD_p$ and $PFD_q$ is best when the center positions $YPP_m$ of the areas $PFD_m$ coincide with the center positions $YP_m$ of the peaks $PPK_m$ respectively. Also the symmetry of each of the signal waveforms $IP_m(YP)$ is best when the center positions $YPP_m$ of the areas $PFD_m$ coincide with the center positions $YP_m$ of the peaks $PPK_m$ respectively. However, as mentioned above, the translational identity between the signal waveforms $IP_m(YP)$ is good whether or not the center positions $YPP_m$ of the areas $PFD_m$ coincide with the center positions $YP_m$ of the peaks $PPK_m$ respectively.

Therefore, in this embodiment, the YP-position of the mark SYM's image is detected by examining the translational identity and symmetry between the signal waveforms $IP_m(YP)$ with making the areas $PFD_m$ scan, and the Y-position YY of the mark SYM is detected based on the YP-position of the mark SYM's image.

The YP-position of the mark SYM's image and the Y-position YY of the mark SYM are detected specifically in the following manner.

In a step 153 subsequent to the step 152 of Fig. 16, the coordinate transforming unit 33B selects a first pair (e.g. pair (1, 2)) out of pairs (p, q) ((1, 2), (2, 3) and (3, 1)) of areas $PFD_p$ and $PFD_q$ and extracts from the signal waveform IP(YP) the signal waveforms $IP_p(YP)$ and $IP_q(YP)$ in the areas $PFD_p$ and $PFD_q$ (see Figs. 18A to 18C). Here, the signal waveform $IP_p(YP)$ is given by the following equations:

$$IP_p(YP) = IP(YP;\ YPL_p \leq YP \leq YPU_p) \tag{8}$$

$$YPL_p = YPP_p - PW/2 \tag{9}$$

$$YPU_p = YPP_p + PW/2, \tag{10}$$

and the signal waveform $IP_q(YP)$ is given by the following equations:

$$IP_q(YP) = IP(YP;\ YPL_q \leq YP \leq YPU_q) \tag{11}$$

$$YPL_q = YPP_q - PW/2 \tag{12}$$

$$YPU_q = YPP_q + PW/2. \tag{13}$$

And in a step 154 the coordinate transforming unit 33B transforms the coordinate of the signal waveform $IP_q$ (YP) by flipping the coordinate system with respect to the middle position $YPP_{p,q}$ $(=(YPP_p + YPP_q)/2)$ to obtain a transformed signal waveform $TIP_q(YP')$ given by the following equation

$$TIP_q(YP') = IP_q(YP), \tag{14}$$

where $YP' = 2YPP_{p,q} - YP$. As a result, the signal waveforms $TIP_q(YP')$ and $IP_p(YP)$ can be directly compared because the areas thereof in the respective horizontal coordinates are the same.

Then the coordinate transforming unit 33B stores the obtained signal waveforms $IP_p(YP)$ and $TIP_q(YP')$ in the coordinate-transformed result store area 42B.

Next, in a step 155, the calculation processing unit 34B reads the signal waveforms $IP_p(YP)$ and $TIP_q(YP')$ from the coordinate-transformed result store area 42B and calculates a normalized correlation $NCF_{p,q}(YPP_1)$ between the signal waveforms $IP_p(YP)$ and $TIP_q(YP')$ which represents the degree of coincidence between the signal waveforms $IP_p(YP)$ and $IP_q(YP)$ in the respective areas $PF_{Dp}$ and $PFD_q$.

Next, in a step 156, it is checked whether or not, for all pairs (p, q), normalized correlations $NCF_{p,q}(YPP_1)$ have been calculated. At this stage because only for the first area pair the normalized correlation $NCF_{p,q}(YPP_1)$ has been calculated, the answer is NO, and then the process proceeds to a step 157.

In the step 157, the coordinate transforming unit 33B selects a next area pair and replaces the area pair (p, q) with the next area pair, and the process proceeds to a step 154.

Until, for all pairs (p, q), a normalized correlation $NCF_{p,q}(YPP_1)$ has been calculated and the answer in the step 156 is YES, the calculation of a normalized correlation $NCF_{p,q}(YPP_1)$ denoting the degree of coincidence in the area pair (p, q) is repeated. When the answer in the step 156 becomes YES, the process proceeds to a step 158.

In the step 158, the calculation processing unit 34B calculates from the normalized correlations $NCF_{p,q}(YPP_1)$ an overall coincidence-degree $NCF(YPP_1)$ given by the equation

$$NCF(YPP_1) = NCF_{1,2}(YPP_1) \times NCF_{2,3}(YPP_1) \times NCF_{3,1}(YPP_1), \tag{15}$$

and stores the overall coincidence-degree $NCF(YPP_1)$ together with the current value of the YP-position $YPP_1$ in the coincidence-degree store area 43B.

Next, in a step 159, it is checked whether or not the areas $PFD_m$ have reached the final positions. At this stage because only for the initial positions the degree of inter-area coincidence has been calculated, the answer is NO, and then the process proceeds to a step 160.

In the step 160, the coordinate transforming unit 33B replaces the YP-position $YPP_1$ with a YP-position $(YPP_1 + \Delta P)$, where $\Delta P$ indicates a unit pitch corresponding to desired resolution in detection of Y-position, and moves the areas $PFD_m$ according to the new YP-position $YPP_1$. And the coordinate transforming unit 33B executes the steps 153 through 158, in the same way as for the initial positions, to calculate an overall coincidence-degree $NCF(YPP_1)$ and store it together with the current value of YP-position $YPP_1$ in the coincidence-degree store area 43B.

Until the answer in the step 159 is YES, in the same way as described above, each time it increases the YP-position $YPP_1$ by the unit pitch $\Delta P$ in the step 160, the coordinate transforming unit 33B executes the steps 153 through 158 to calculate an overall coincidence-degree $NCF(YPP_1)$ and store it together with a current value of YP-position $YPP_1$ in the coincidence-degree store area 43B.

When the areas $PFD_m$ have reached the final positions, the answer in the step 159 is YES, and the process proceeds to a step 161.

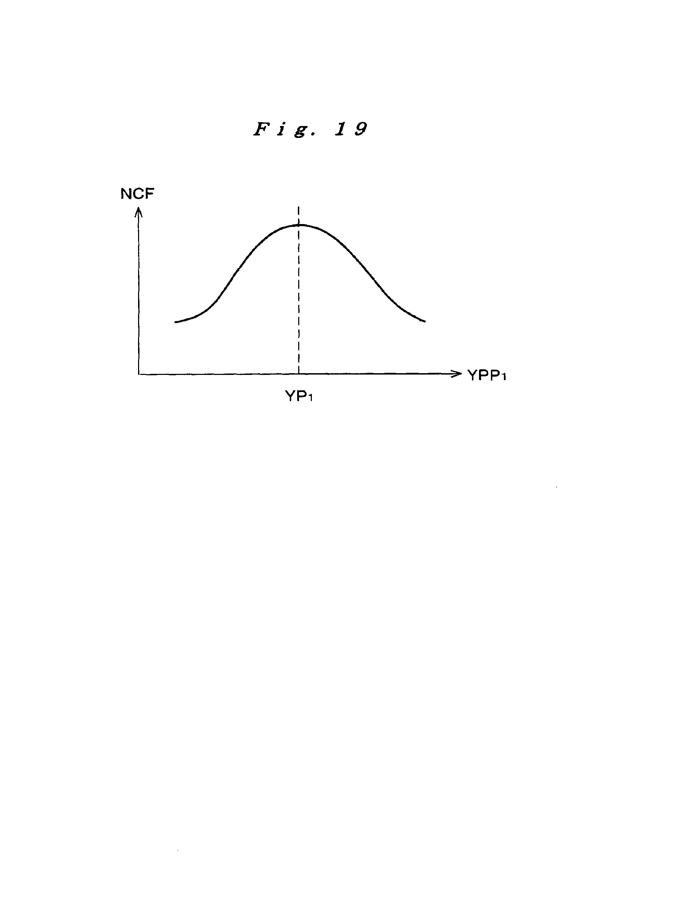

In the step 161, the mark position information calculating unit 35B reads position information WPV of the wafer W from the wafer interferometer 18 and reads the coincidence-degrees $NCF(YPP_1)$ and the corresponding YP-positions $YPP_1$ from the coincidence-degree store area 43B and examines the relation of the coincidence-degree $NCF(YPP_1)$ to the varying YP-position $YPP_1$, whose example is shown in Fig. 19. In Fig. 19 the coincidence-degree $NCF(YPP_1)$ takes on a maximum when the YP-position $YPP_1$ coincides with the peak position $YP_1$. Therefore, the mark position information calculating unit 35B sets the YP-position $YPP_1$'s value as the peak position $YP_1$, at which value the coincidence-degree $NCF(YPP_1)$ takes on a maximum in the relation to the varying YP-position $YPP_1$ and then obtains the Y-position YY of the mark SYM based on the peak position $YP_1$ obtained and the position information WPV of the wafer W.

In detection of the peak position $YP_1$ in this embodiment when the coincidence-degree $NCF(YPP_1)$ as a function of the YP-position $YPP_1$ has a meaningful peak to determine a maximum from, a mark-position-undetectable flag is switched off while it is switched on when the coincidence-degree $NCF(YPP_1)$ does not have a meaningful peak to determine a maximum from.

After the completion of the detection of the Y-position YY of the mark SYM, the execution of the subroutine 106 ends, and the process returns to the main routine.

Referring back to Fig. 6, a step 107 checks, by checking whether or not the mark-position-undetectable flag is off, whether or not the Y-position YY of the mark SYM could be calculated. If the answer is NO, a process such as redetection of the mark SYM, detecting the position of another Y-mark, etc., is started, otherwise the process proceeds to a step 108.

Next, in steps 108 through 112 the Y-position Yθ of the mark SθM is obtained in the same way as in the steps 102 through 106. Subsequently, a step 113 checks, by checking whether or not a mark-position-undetectable flag is off, whether or not the Y-position Yθ of the mark SθM could be calculated. If the answer is NO, a process such as redetection of the mark SθM, detecting the position of another θ-mark, etc., is started, otherwise the process proceeds to a step 121.

Subsequently, in the step 121 the main control system 20 calculates wafer-rotation amount $\theta_s$ based on the Y-positions YY, Yθ of the Y-mark SYM and the θ-mark SθM obtained.

Next, in the step 123 the main control system 20 sets the magnification of the alignment microscope AS to be high and detects sampling marks in shot areas by use of the alignment microscope AS while positioning the wafer stage WST via the wafer-stage driving portion 24, with monitoring measurement values of the wafer interferometer 18 and using the obtained wafer-rotation amount $\theta_s$, such that each sampling mark is placed underneath the alignment microscope AS. Here, the main control system 20 obtains the coordinates of each sampling mark based on the measurement value of the alignment microscope AS for the sampling mark and a corresponding measurement value of the wafer interferometer 18.

Subsequently, in a step 124 the main control system 20 performs a statistic computation using the least-squares method disclosed in, for example, Japanese Patent Application Laid-Open No. 61-44429 and U.S. Patent No. 4,780,617 corresponding thereto to obtain six parameters with respect to the arrangement of shot areas on the wafer W: rotation θ, scaling factors $S_X$, $S_Y$ in the X- and Y-directions, orthogonality ORT, and offsets $O_X$, $O_Y$ in the X- and Y-directions. The disclosure in the above Japanese Patent Application Laid-Open and U.S. Patent is incorporated herein by reference as long as the national laws in designated states or elected states, to which this international application is applied, permit.

Next, in a step 125 the main control system 20 calculates the arrangement coordinates, i.e. an overlay-corrected position, of each shot area on the wafer W by substituting the six parameters into predetermined equations.

Because the process in the steps 123, 124, 125 is disclosed in detail in, for example, Japanese Patent Application Laid-Open No. 61-44429 and U.S. Patent No. 4,780,617 corresponding thereto and is known, the detailed description is omitted.

After that, the main control system 20 performs exposure operation of a step-and-scan type where moving by step each shot area on the wafer W to a scan start position and transferring a reticle pattern onto the wafer with moving synchronously the reticle stage RST and wafer stage WST in the scan direction based on the arrangement coordinates of each shot area and base-line distance measured in advance are repeated. By this, an exposure process is completed.

As described above, according to this embodiment, the pupil-divided images, with symmetry and translational identity, of the illumination areas ASL1, ASL2 on a wafer W are picked up, and in order to obtain the distance between the symmetric, pupil-divided images of the illumination area ASL1 and the distance between the symmetric, pupil-divided images of the illumination area ASL2, with moving the two areas $FD_L$ and $FD_R$ on the image coordinate system (XF, YF), the degree of coincidence between the two areas is calculated in light of the translational identity between the signal waveforms in the areas. And by obtaining the position of the two areas at which the degree of coincidence between the two areas is maximal, defocus amount, i.e. Z-position information, of each of the illumination areas ASL1 and ASL2 is detected, so that Z-position information of the wafer W can be accurately detected.

Furthermore, according to this embodiment the image of the mark SYM (SθM) formed on the illumination area ASL0 is picked up which image has symmetry and translational identity and, while moving the plurality of areas $PFD_m$ on the pick-up coordinate system (XP, YP), the degrees of coincidence in pairs of areas selected out of the plurality of areas are calculated in light of symmetry between signal waveforms in each of the pairs, and the overall degree of inter-area coincidence for the areas as a function of the position of the areas is calculated, and then by obtaining the position of the areas at which the overall degree of inter-area coincidence is maximal, the Y-position of the mark SYM (SθM) can be accurately detected.

Moreover, according to this embodiment fine alignment marks are viewed based on the accurately detected Y-positions of the marks SYM and SθM to accurately calculate arrangement coordinates of shot areas SA on the wafer W. And based on the calculating result the wafer W is accurately aligned, so that the pattern of a reticle R can be accurately transferred onto the shot areas SA.

Furthermore, in the above embodiment the number of the plurality of areas used in detection of the Y-position of the mark SYM, SθM is three, and the product of the degrees of inter-area coincidence in three pairs of areas is taken as the overall degree of inter-area coincidence. Therefore, an accidental increase over the original value in the degree of inter-area coincidence in a pair of areas due to noise, etc., can be prevented from affecting the overall degree of inter-area coincidence, so that the Y-position of the mark SYM (SθM) can be accurately detected.

Furthermore, because in this embodiment the coordinate transforming units 33A and 33B are provided for transforming coordinates by a method corresponding to symmetry or translational identity between a signal waveform in one area and a signal waveform in another area, the degree of inter-area coincidence can be readily detected.

Furthermore, because in this embodiment a normalized correlation between the coordinate-transformed signal waveform in the one area and the signal waveform in the other area is calculated, the degree of inter-area coincidence can be accurately calculated.

Yet further, because in this embodiment the degree of inter-area coincidence in a signal waveform along one dimension obtained from a picked-up two-dimensional image is calculated, the position information of the object can be readily obtained.

Furthermore, although in the first embodiment the product of the degrees of inter-area coincidence in three pairs of areas is used as the overall degree of inter-area coincidence, the sum or average of the degrees of inter-area coincidence in the three pairs of areas may be used instead. Also in this case, an accidental increase over the original value in the degree of inter-area coincidence in a pair of areas due to noise, etc., can be prevented from affecting the overall degree of inter-area coincidence.

Still further, although in the first embodiment a normalized correlation between the coordinate-transformed signal waveform in the one area and the signal waveform in the other area is calculated, the sum of the absolute values of the differences between values at points in the coordinate-transformed signal waveform in the one area and values at corresponding points in the signal waveform in the other area may be used instead, in which case the calculation is simple and the sum reflects directly the degree of coincidence, so that the degree of inter-area coincidence can be readily calculated. Incidentally, in this case the degree of inter-area coincidence becomes higher as the sum becomes smaller.

Yet further, also by calculating the sum of the squares of differences between values at points in the coordinate-transformed signal waveform in the one area and values at corresponding points in the signal waveform in the other area or the square root of the sum, the degree of inter-area coincidence can be calculated.

The calculation of the sum of the squares of differences or the square root of the sum comprises selecting a pair out of signal waveforms $IP_1(YP)$, $IP_2(YP)$, $IP_3(YP)$ in the areas $PFD_1$, $PFD_2$, $PFD_3$, and subtracting from the value at each point of each signal waveform its mean to remove its offset and dividing the value at each point of the signal waveform, whose offset is removed, by its standard deviation, the subtracting and dividing composing normalization.

Then, transforming coordinates by translation such that the ranges of the two normalized signal waveforms in the respective horizontal coordinates are the same is performed if necessary, and the sum of the squares of the differences between the two signal waveforms at points in the range is calculated.

And while moving the areas $PFD_1$, $PFD_2$, $PFD_3$ as in the above embodiment, the sum of the squares of the differences for each position of the areas is calculated; here the sum's value being smaller indicates the degree of coincidence being higher. In this case, the calculation is simple and the sum reflects directly the degree of coincidence, so that the degree of coincidence can be readily calculated.

Instead of the sum of the squares the square root of the sum may be used.

Moreover, if the foregoing method is applied to three or more waveforms, the overall degree of inter-area coincidence for the three or more waveforms is assessed at one time.

It is noted that the foregoing method using the sum of the squares or the square root of the sum is equivalent to a method where the differences between a mean waveform of a plurality of waveforms and them are calculated and tested.

Furthermore, although in the first embodiment the correlation between signal waveforms is calculated, the correlation between each signal waveform and a mean waveform thereof may be calculated to obtain the degree of inter-area coincidence.

Yet further, although in the first embodiment the degree of inter-area coincidence is calculated from the degree of symmetry in detecting the Y-position of the mark SYM (SθM), an overall coincidence-degree $NCF'(YPP_1)$ which takes into account both symmetry and translational identity can be calculated in the following manner.

First, a normalized correlation between the signal waveforms $IP_p(YP)$ and $TIP_q'(YP")$ given by the equation (16) is calculated which correlation represents a coincidence-degree $NC1_{p,q}(YPP_1)$ with respect to translational identity between the signal waveforms $IP_p(YP)$ and $IP_q(YP)$,

$$TIP_q' \; (YP''(=YP-PW1-PW2))=IP_q(YP). \tag{16}$$

And an overall coincidence-degree $NC1(YPP_1)$ with respect to translational identity is calculated by using the equation

$$NC1(YPP_1)=NC1_{1,2}(YPP_1)\times NC1_{2,3}(YPP_1)\times NC1_{3,1}(YPP_1), \tag{17}$$

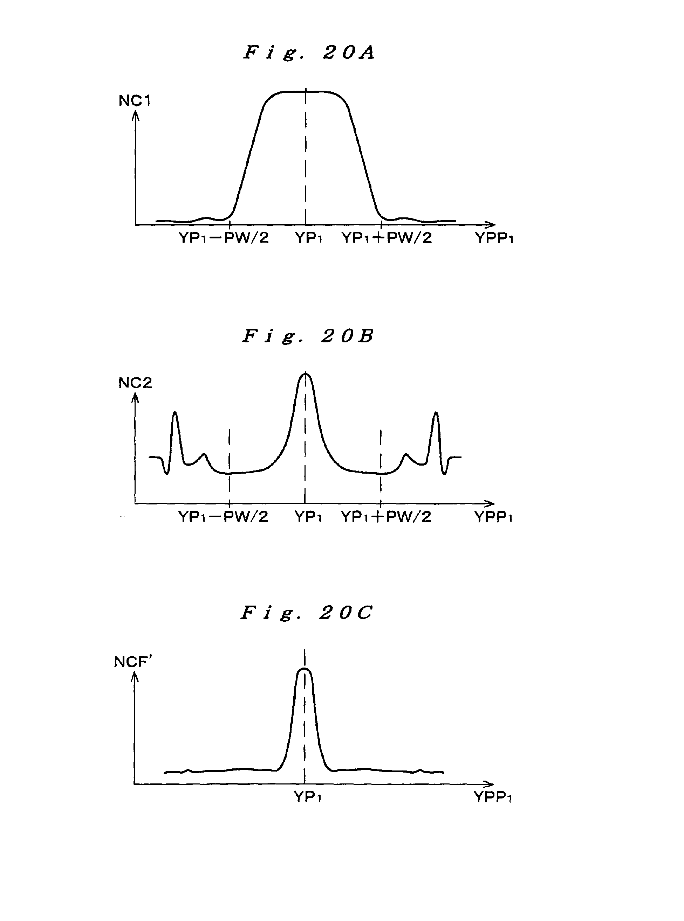

whose values form a shape as shown in Fig. 20A, which is a trapezoid almost flat in the $YPP_1$'s range of $(YP_1-PW/2)$ through $(YP_1+PW/2)$.

Meanwhile, a degree of intra-area coincidence $NC2_r(YPP_1)$ is calculated which is represented by a normalized correlation denoting the degree of symmetry of the signal waveform in an area $PFD_r$ of the areas $PFD_m$ (m=1 through 3) in the following manner.

The signal waveform $IP_r(YP)$ in the area $PFD_r$ is given by the equations using the signal waveform $IP(YP)$ (see Fig. 18A to 18C),

$$IP_r(YP)=IP(YP; YPL_r\leq YP \leq YPU_r) \tag{8'}$$

$$YPL_r=YPP_r-PW/2 \tag{9'}$$

$$YPU_r=YPP_r+PW/2. \tag{10'}$$

Next, a transformed signal waveform $TIP_r''(YP'')$ is obtained by flipping the coordinate system of the signal waveform $IP_r(YP)$ with respect to the center position $YPP_r$, which is given by the following equation

$$TIP_r''(YP'')=IP_r(YP), \tag{14'}$$

where $YP''=2YPP_r-YP$. As a result, the signal waveforms $TIP_r''(YP'')$ and $IP_r(YP)$ can be directly compared because the areas thereof in the respective horizontal coordinates are the same.

Subsequently, the normalized correlation $NC2_r(YPP_1)$ between the signal waveforms $IP_r(YP)$ and $TIP_r''(YP'')$ is calculated which represents the degree of symmetry (or intra-area coincidence) of the signal waveform $IP_r(YP)$.

The degree of intra-area coincidence $NC2_r(YPP_1)$ obtained is shown in Fig. 20B which has a maximum peak where $YPP_1=YP_1$ and other peaks. The maximum peak is an only peak in the $YPP_1$'s range of $(YP_1-PW/2)$ through $(YP_1+PW/2)$, where the degree of coincidence $NC1(YPP_1)$ is great.

A degree of inter-area coincidence $NCF'(YPP_1)$ given by the equation

$$NCF'(YPP_1)=NC1(YPP_1)\times NC2_r(YPP_1) \tag{18}$$

is calculated, which has, as shown in Fig. 20C, an only peak where YP-position $YPP_1=YP_1$. Therefore, by detecting YP-position $YPP_1$ at which the overall degree of inter-area coincidence $NCF'(YPP_1)$, which takes into account both symmetry and translational identity, takes on a maximum, the value $YP_1$ can be obtained. After this, the Y-position of the mark SYM (S$\theta$M) can be accurately detected by the same process as in the first embodiment.

Instead of the degree of intra-area coincidence $NC2_r(YPP_1)$ can be used the overall degree of intra-area coincidence $NC2(YPP_1)$ given by the equation

$$NC2(YPP_1)=NC2_1(YPP_1) \times NC2_2(YPP_1) \times NC2_3(YPP_1). \tag{19}$$

Furthermore, instead of the overall degree of coincidence $NCF'(YPP_1)$ a degree of intra-area coincidence $NCF''(YPP_1)$ may be used that takes into account only symmetry, and may be the degree of intra-area coincidence $NC2_r(YPP_1)$ or the overall degree of intra-area coincidence $NC2(YPP_1)$. If using the overall degree of intra-area coin-

cidence $NC2(YPP_1)$ as the degree of intra-area coincidence $NCF''(YPP_1)$, the peak where $YPP_1=YP_1$ can be identified to detect the mark's position while if using the degree of intra-area coincidence $NC2_r(YPP_1)$ as the degree of intra-area coincidence $NCF''(YPP_1)$, the peak cannot be identified because of some peaks as shown in Fig. 20B.

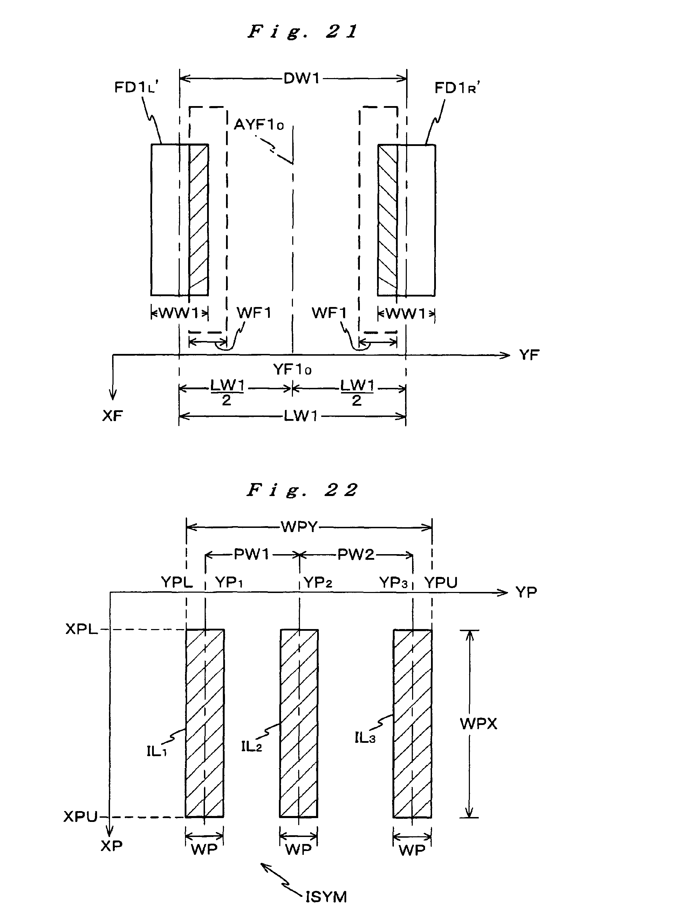

Moreover, although in the first embodiment a signal waveform along one dimension (YF or YP axis) obtained from a picked-up two-dimensional image is analyzed, the two-dimensional image may be directly analyzed to detect position. For example, in the measuring of defocus amount two one-dimensional areas $FD1_L'$ and $FD1_R'$, as shown in Fig. 21, corresponding to the two one-dimensional areas $FD1_L$ and $FD1_R$ in Fig. 11B are defined. The areas $FD1_L'$ and $FD1_R'$ are symmetric with respect to an axis $AYF1_0$ that is through YF-position $YF1_0$ and parallel to the YF-axis and have a width WW1 ($\geq$WF1) in the YF direction, and the distance LW1 in the YF direction between the center positions of the areas $FD1_L'$ and $FD1_R'$ is variable which is called an "area pitch LW1" hereinafter. While moving the areas $FD1_L'$ and $FD1_R'$ with keeping the symmetry with respect to the axis $AYF1_0$, the degree of inter-area coincidence that represents the degree of translational identity between two two-dimensional images is calculated and analyzed to detect the image pitch DW1. Also for the detection of the Y-position of the mark SYM (S$\theta$M) the two-dimensional image can be used.

While, in the first embodiment, focusing the alignment microscope AS is performed to pick up the images of the marks SYM and S$\theta$M, it can also be performed to view marks on the reference mark plate FM.

«A second embodiment»

A second embodiment of the present invention will be described below. An exposure apparatus according to this embodiment has almost the same construction as the exposure apparatus 100 of the first embodiment and is different in that it detects the X-Y position of the mark SYM (S$\theta$M), while in the first embodiment the Y-position of the mark SYM (S$\theta$M) is detected. That is, only the processes in the subroutines 106, 112 in Fig. 6 are different, focusing on which the description will be presented. The same symbols are used to indicate components that are the same as or equivalent to those in the first embodiment, and the explanations of the components are omitted.

In the same way as in the first embodiment, the steps 101 through 105 in Fig. 6 are executed to focus on the mark SYM and pick up its image and store first pick-up data IMD1 of the mark SYM in the pick-up data store area 41B. Fig. 22 shows the two-dimensional image ISYM of the mark SYM contained in the first pick-up data IMD1. In Fig. 22, XP and YP directions in the light receiving face of the pick-up device 74 are conjugate to the X- and Y-directions in the wafer coordinate system respectively.

As shown in Fig. 22, the two-dimensional image ISYM has line images $IL_m$ corresponding to the line-features $SML_m$ (m=1 through 3; see Fig. 7B) of the mark SYM and arranged in the YP direction and spatial images between them. The line images $IL_m$ are a rectangular having an XP-direction dimension WPX and a YP-direction width WP; the edge in the -XP direction of the line images $IL_m$ is located at XP-position XPL while the edge in the +XP direction is located at XP-position XPU (=XPL+WPX), and PW1 and PW2 indicate the distance between the center positions $YP_1$, $YP_2$ in the YP direction of the line images $IL_1$ and $IL_2$ and the distance between the center positions $YP_2$, $YP_3$ in the YP direction of the line images $IL_2$ and $IL_3$ respectively, and the distance WPY between YP-position YPL of the edge in the -YP direction of the line image $IL_1$ and YP-position YPU of the edge in the +YP direction of the line image $IL_3$ equals (PW1+PW2+WP). The dimensions WPX, WP and distances PW1, PW2 are supposed to be known from design information, etc.

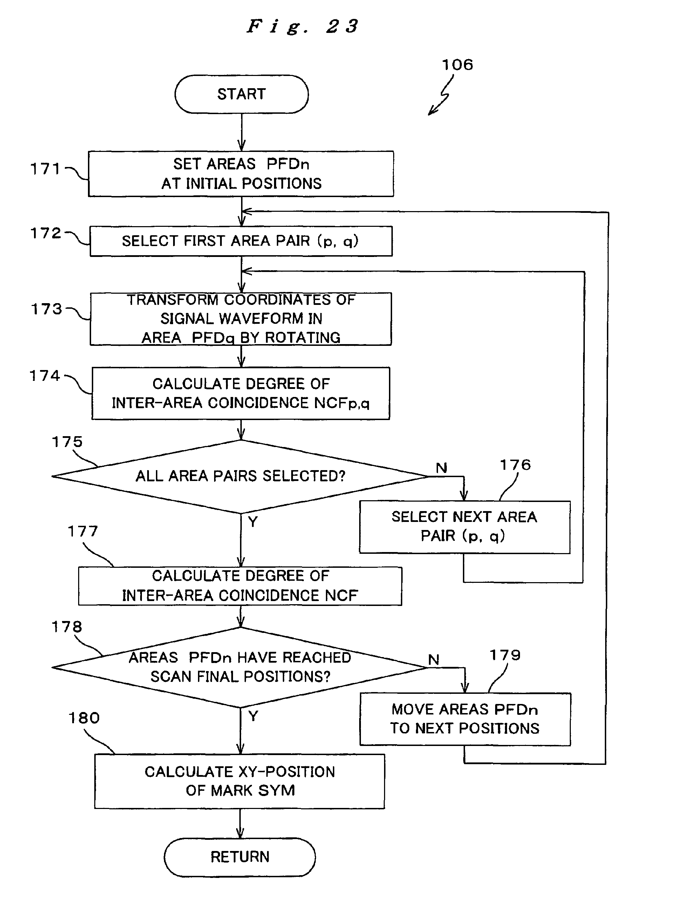

In a subroutine 106 in Fig. 23 the X-Y position of the mark SYM is calculated from the two-dimensional image ISYM(XP, YP) contained in the first pick-up data IMD1 in the pick-up data store area 41B.

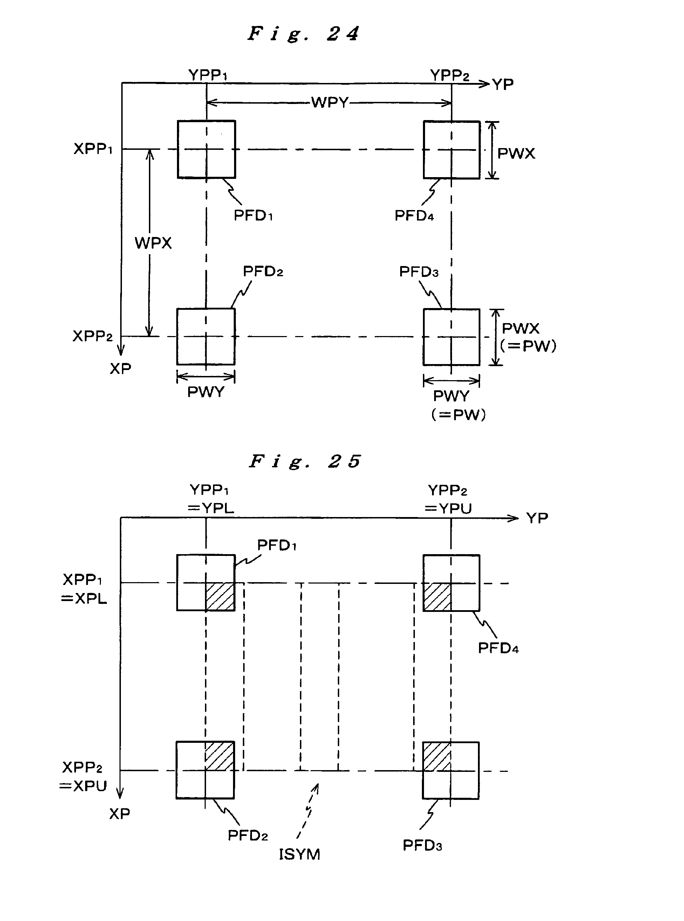

First, in a step 171 of the subroutine 106 as shown in Fig. 16, the coordinate transforming unit 33B of the coincidence-degree calculating unit 32B reads the first pick-up data IMD1 containing the two-dimensional image ISYM (XP, YP) from the pick-up data store area 41B and subsequently defines four two-dimensional areas $PFD_1$, $PFD_2$, $PFD_3$, $PFD_4$ as shown in Fig. 24. Here, the areas $PFD_n$ (n=1 through 4) are a square having a width PW in the XP and YP directions; the center positions of the areas $PFD_1$, $PFD_2$, $PFD_3$, $PFD_4$ are set to be coordinates $(XPP_1, YPP_1)$, $(XPP_2, YPP_1)$, $(XPP_2, YPP_2)$, $(XPP_1, YPP_2)$ respectively, where $XPP_2=XPP_1+WPX$ and $YPP_2=YPP_1+WPY$, and the center coordinates $(XPP_1, YPP_1)$ of the area $PFD_1$ are variable.

Subsequently, the coordinate transforming unit 33B determines initial and final positions for the scan of the areas $PFD_n$ and sets the areas $PFD_n$ at the initial positions. Here the initial values of the center coordinates $XPP_1$, $YPP_1$ can be small enough, but preferably are set to be slightly smaller than the minimum in the range of XPL and the minimum in the range of YPL respectively, which are predicted from design, in terms of quickly measuring the X-Y position of the mark SYM. Further, the final values of the center coordinates $XPP_1$, $YPP_1$ can be large enough, but preferably are set to be slightly larger than the maximum in the range of XPL and the maximum in the range of YPL respectively, which are predicted from design, in terms of quickly measuring the X-Y position of the mark SYM.

Next, the principle of detecting the X-Y position (YX, YY) of the mark SYM on the wafer W in steps 172 and later will be briefly described.

First in the detection of the X-Y position (YX, YY) in this embodiment, the position (XPL, YPL) is detected in the image space by making the areas PFD$_n$ scan two-dimensionally from the initial position through the final position with maintaining the distances between the areas PFD$_n$. The reason why the areas PFD$_n$ are made to scan with maintaining the distances between them is that, at a point of time in the scan the coordinates (XPP$_1$, YPP$_1$) coincide with the position (XPL, YPL), when there is symmetry between images in the areas PFD$_n$.

That is, when the coordinates (XPP$_1$, YPP$_1$) coincide with the position (XPL, YPL), there is as shown in Fig. 25 rotational identity in shape between images in the areas PFD$_n$, and there is also symmetry between images in areas PFD$_n$ next to each other in the XP or YP direction. The identity and symmetry will be explained in more detail in the following. For example, an image signal IS$_1$(XP, YP) in the area PFD$_1$ and an image signal IS$_2$(XP, YP) in the area PFD$_2$, which are next to each other in the XP direction, have rotational identity where the image signal IS$_2$(XP, YP) is obtained by rotating the image signal IS$_1$(XP, YP) through 90 degrees counterclockwise and symmetry with respect to a line through an XP-coordinate XPP$_{1,2}$ (=(XPP$_1$+XPP$_2$)/2) and parallel to the YP axis, which is called "YP-axis-symmetry" hereinafter. Furthermore, the image signal IS$_1$(XP, YP) in the area PFD$_1$ and image signal IS$_4$(XP, YP) in the area PFD$_4$, which are next to each other in the YP direction, have rotational identity where the image signal IS$_4$(XP, YP) is obtained by rotating the image signal IS$_1$(XP, YP) through 270 degrees counterclockwise and symmetry with respect to a line through an YP-coordinate YPP$_{1,2}$ (=(YPP$_1$+YPP$_2$)/2) and parallel to the XP axis, which is called "XP-axis-symmetry" hereinafter. Herein, the plus direction of angles of rotation is the counterclockwise in the drawing of Fig. 25.

In this embodiment it is checked by analyzing the degree of rotational identity whether or not the coordinates (XPP$_1$, YPP$_1$) coincide with the position (XPL, YPL), and based on the two-dimensional position of the image of the mark SYM the X-Y position (YX, YY) of the mark SYM is detected.

Specifically, the two-dimensional position of the image and the X-Y position (YX, YY) of the mark SYM are detected in the following manner.

Referring back to Fig. 23, in a step 172 subsequent to the step 171, the coordinate transforming unit 33B selects a first pair (e.g. pair (1, 2)) out of pairs (p, q) ((1, 2), (2, 3), (3, 4) and (4, 1)) of areas PFD$_p$ and PFD$_q$ that are next to each other and extracts from the two-dimensional image ISYM(XP, YP) the image signal IS$_1$(XP, YP), IS$_2$(XP, YP) in the areas PFD$_1$, PFD$_2$ (see Fig. 25).

Next, in a step 173 the coordinate transforming unit 33B transforms coordinates of the image signal IS$_1$(XP, YP) by rotating the coordinate system whose origin is located at the center point (XPP$_1$, YPP$_1$) of the area PFD$_1$ through -90 degrees about the center point (XPP$_1$, YPP$_1$). First in the transformation, calculated is a transformed signal SIS$_1$(XP', YP') given by the following equations for translating the coordinate system such that the center point (XPP$_1$, YPP$_1$) of the area PFD$_1$ becomes its origin:

$$SIS_1(XP', YP') = IS_1(XP, YP) \tag{20}$$

$$XP' = XP - XPP_1 \tag{21}$$

$$YP' = YP - YPP_1. \tag{22}$$

Then, calculated from the transformed signal SIS$_1$(XP', YP') is a transformed signal RIS$_1$(XP", YP") given by the following equations for rotating the coordinate system about its origin through -90 degrees:

$$RIS_1(XP", YP") = SIS_1(XP', YP') \tag{23}$$

$$\begin{pmatrix} XP'' \\ YP'' \end{pmatrix} = R(\theta(=90°))\begin{pmatrix} XP' \\ YP' \end{pmatrix}$$

$$= \begin{pmatrix} \cos(\theta(=90°)) & -\sin(\theta(=90°)) \\ \sin(\theta(=90°)) & \cos(\theta(=90°)) \end{pmatrix}\begin{pmatrix} XP' \\ YP' \end{pmatrix}$$

$$= \begin{pmatrix} 0 & -1 \\ 1 & 0 \end{pmatrix}\begin{pmatrix} XP' \\ YP' \end{pmatrix}$$

$$= \begin{pmatrix} -YP' \\ XP' \end{pmatrix} \qquad \cdots (24)$$

Next, the coordinate transforming unit 33B obtains a transformed signal $TIS_1(XP^{\#}, YP^{\#})$ by translating the coordinate system such that the center point $(XPP_2, YPP_1)$ of the area $PFD_2$ becomes its origin, using the following equations:

$$TIS_1(XP^{\#}, YP^{\#}) = RIS_1(XP'', YP'') \tag{25}$$

$$XP^{\#} = XP'' + XPP_2 \tag{26}$$

$$YP^{\#} = YP'' + YPP_1. \tag{27}$$

As a result, the ranges of the transformed signal $TIS_1(XP^{\#}, YP^{\#})$ and the image signal $IS_2(XP, YP)$ in the respective coordinate systems are the same.

The coordinate transforming unit 33B stores the transformed signal $TIS_1(XP^{\#}, YP^{\#})$ and the image signal $IS_2$ (XP, YP) in the coordinate-transformed result store area 42B.

Next, in a step 174, the calculation processing unit 34B reads the transformed signal $TIS_1(XP^{\#}, YP^{\#})$ and the image signal $IS_2(XP, YP)$ from the coordinate-transformed result store area 42B and calculates a normalized correlation $NCF_{1,2}(XPP_1, YPP_1)$ between the transformed signal $TIS_1(XP^{\#}, YP^{\#})$ and the image signal $IS_2(XP, YP)$ which represents the degree of coincidence between the image signals $IS_1(XP, YP)$, $IS_2(XP, YP)$ in the respective areas $PFD_1$ and $PFD_2$.

Next, in a step 175, it is checked whether or not, for all pairs (p, q), a normalized correlation $NCF_{p,q}(XPP_1, YPP_1)$ has been calculated. At this stage because only for the first area pair the normalized correlation $NCF_{p,q}(XPP_1, YPP_1)$ has been calculated, the answer is NO, and then the process proceeds to a step 176.

In the step 176, the coordinate transforming unit 33B selects a next area pair and replaces the area pair (p, q) with the next area pair, and the process proceeds to a step 173.

Until, for all pairs (p, q), a normalized correlation $NCF_{p,q}(XPP_1, YPP_1)$ has been calculated and the answer in the step 175 is YES, the calculation of a normalized correlation $NCF_{p,q}(XPP_1, YPP_1)$ denoting the degree of coincidence in the area pair (p, q) is repeated. When the answer in the step 175 becomes YES, the process proceeds to a step 177.

In the step 177, the calculation processing unit 34B calculates from the normalized correlations $NCF_{p,q}(XPP_1, YPP_1)$ an overall coincidence-degree $NCF(XPP_1, YPP_1)$ given by the equation

$$NCF(XPP_1, YPP_1) = NCF_{1,2}(XPP_1, YPP_1) \times NCF_{2,3}(XPP_1, YPP_1) \times$$

$$NCF_{3,4}(XPP_1, YPP_1) \times NCF_{4,1}(XPP_1, YPP_1), \tag{28}$$

and stores the overall coincidence-degree $NCF(XPP_1, YPP_1)$ together with the current values of the coordinates $(XPP_1, YPP_1)$ in the coincidence-degree store area 43B.

Next, in a step 178, it is checked whether or not the areas $PFD_m^-$ have reached the final positions. At this stage because only for the initial positions the degree of inter-area coincidence has been calculated, the answer is NO, and then the process proceeds to a step 179.

In the step 179, the coordinate transforming unit 33B increases the coordinates $(XPP_1, YPP_1)$ by a pitch corresponding to desired resolution, and moves the areas $PFD_m$ according to the new coordinates $(XPP_1, YPP_1)$. And the coordinate transforming unit 33B executes the steps 172 through 177, in the same way as for the initial positions, to calculate an overall coincidence-degree $NCF(XPP_1, YPP_1)$ and store it together with the current coordinates $(XPP_1, YPP_1)$ in the coincidence-degree store area 43B.

Until the answer in the step 178 is YES, in the same way as described above, each time it increases the coordinates $(XPP_1, YPP_1)$ by the pitch in the step 179, the coordinate transforming unit 33B executes the steps 172 through 177 to calculate an overall coincidence-degree $NCF(XPP_1, YPP_1)$ and store it together with current coordinates $(XPP_1, YPP_1)$ in the coincidence-degree store area 43B.

When the areas $PFD_m$ have reached the final positions, the answer in the step 178 is YES, and the process proceeds to a step 180.

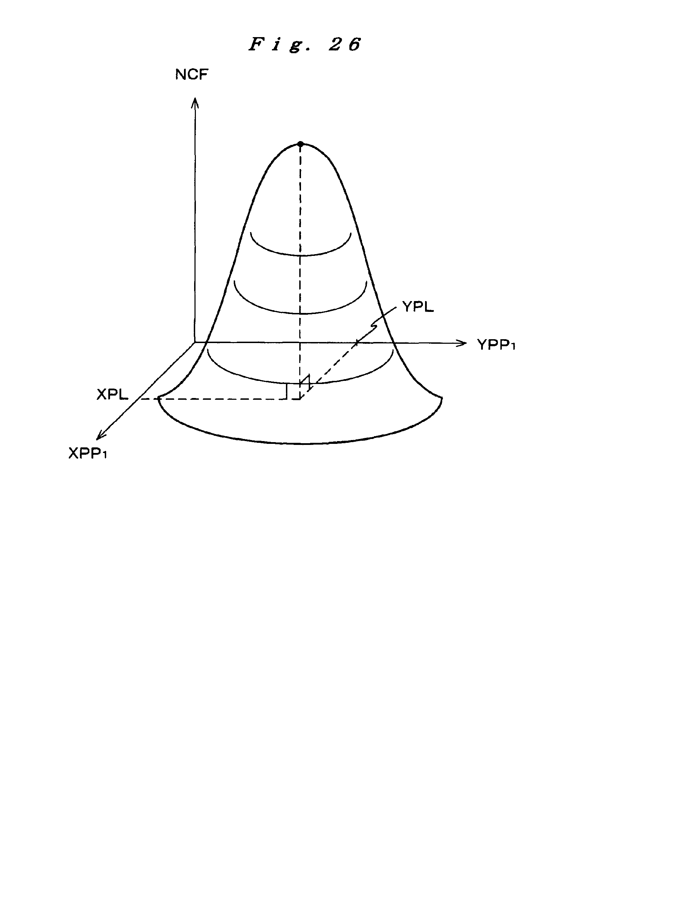

In the step 180, the mark position information calculating unit 35B reads position information WPV of the wafer W from the wafer interferometer 18 and reads the coincidence-degrees $NCF(XPP_1, YPP_1)$ and the corresponding coordinates $(XPP_1, YPP_1)$ from the coincidence-degree store area 43B and examines the relation of the coincidence-degree $NCF(XPP_1, YPP_1)$ to the varying coordinates $(XPP_1, YPP_1)$, whose example is shown in Fig. 26. In Fig. 26 the coincidence-degree $NCF(XPP_1, YPP_1)$ takes on a maximum when the coordinates $(XPP_1, YPP_1)$ coincides with the position (XPL, YPL). Therefore, the mark position information calculating unit 35B sets the coordinates $(XPP_1, YPP_1)$ as the position (XPL, YPL), at which coordinates the coincidence-degree $NCF(XPP_1, YPP_1)$ takes on a maximum in the relation to the varying coordinates $(XPP_1, YPP_1)$ and then obtains the X-Y position (YX, YY) of the mark SYM based on the position (XPL, YPL) obtained and the position information WPV of the wafer W.

In detection of the position (XPL, YPL) in this embodiment when the coincidence-degree $NCF(XPP_1, YPP_1)$ as a function of the coordinates $(XPP_1, YPP_1)$ has a meaningful peak to determine a maximum from, a mark-position-undetectable flag is switched off while it is switched on when the coincidence-degree $NCF(XPP_1, YPP_1)$ does not have a meaningful peak to determine a maximum from.

After the completion of the detection of the X-Y position (YX, YY) of the mark SYM, the execution of the subroutine 106 ends, and the process returns to the main routine.

After that, in the same process shown in Fig. 6 as in the first embodiment except that the process in the subroutine 112 is the same as the one in the foregoing subroutine 106, the wafer-rotation amount $\theta_s$ is calculated, and then the six parameters with respect to the arrangement of shot areas on the wafer W: rotation $\theta$, scaling factors $S_X$, $S_Y$ in the X- and Y-directions, orthogonality ORT, and offsets $O_X$, $O_Y$ in the X- and Y-directions are calculated to calculate the arrangement coordinates, i.e. an overlay-corrected position, of each shot area on the wafer W.

After that, in the same way as in the first embodiment the main control system 20 performs exposure operation of a step-and-scan type where moving by step each shot area on the wafer W to a scan start position and transferring a reticle pattern onto the wafer with moving synchronously the reticle stage RST and wafer stage WST in the scan direction based on the arrangement coordinates of each shot area and base-line distance measured in advance are repeated.

As described above, according to this embodiment the Z-position of a wafer W can be accurately detected as in the first embodiment. Further, the image of the mark SYM (S$\theta$M) formed on the illumination area ASL0 is picked up and, while moving the plurality of areas $PFD_m$ on the pick-up coordinate system (XP, YP), the degrees of inter-area coincidence in pairs of areas selected out of the plurality of areas are calculated in light of rotational identity between signal waveforms in each of the pairs, and the overall degree of inter-area coincidence for the areas as a function of the position of the areas is calculated, and then by obtaining the position of the areas at which the overall degree of inter-area coincidence is maximal, the X-Y position of the mark SYM (S$\theta$M) can be accurately detected. Moreover, according to this embodiment fine alignment marks are viewed based on the accurately detected Y-positions of the marks SYM and S$\theta$M to accurately calculate arrangement coordinates of shot areas SA on the wafer W. And based on the calculating result the wafer W is accurately aligned, so that the pattern of a reticle R can be accurately transferred onto the shot areas SA.

Furthermore, in the above embodiment the number of the plurality of areas used in detection of the X-Y position of the mark SYM, S$\theta$M is four, and the product of the degrees of inter-area coincidence in four pairs of areas that are next to each other is taken as the overall degree of inter-area coincidence. Therefore, an accidental increase in the degree of inter-area coincidence in a pair of areas due to noise, etc., can be prevented from affecting the overall degree of coincidence, so that the X-Y position of the mark SYM (S$\theta$M) can be accurately detected.

Further, as in the first embodiment because the coordinate transforming units 33A and 33B are provided for transforming coordinates by a method corresponding to symmetry or rotational identity between an image signal in one area and an image signal in another area, the degree of inter-area coincidence can be readily detected. Yet further, as in the first embodiment because a normalized correlation between the coordinate-transformed image signal in the one area and the image signal in the other area is calculated, the degree of inter-area coincidence can be accurately calculated.

Moreover, although in the second embodiment the product of the degrees of coincidence in four pairs (p, q) of areas $PFD_p$, $PFD_q$ that are next to each other is taken as the overall degree of coincidence, the product of the degrees of coincidence in three pairs (p, q) of areas $PFD_p$, $PFD_q$ that are next to each other may be used as the overall degree of coincidence. Further, the product of the degrees of coincidence in pairs (1, 3), (2, 4) of areas that are on a diagonal may be taken as the overall degree of coincidence, in which case there is rotational identity through 180 degrees in the pair.

Still further, although in the second embodiment the degrees of coincidence are calculated in light of rotational identity between the image signals $IS_n$ in areas $PFD_n$, those may be calculated in light of the symmetry between the image signals in areas next to each other.

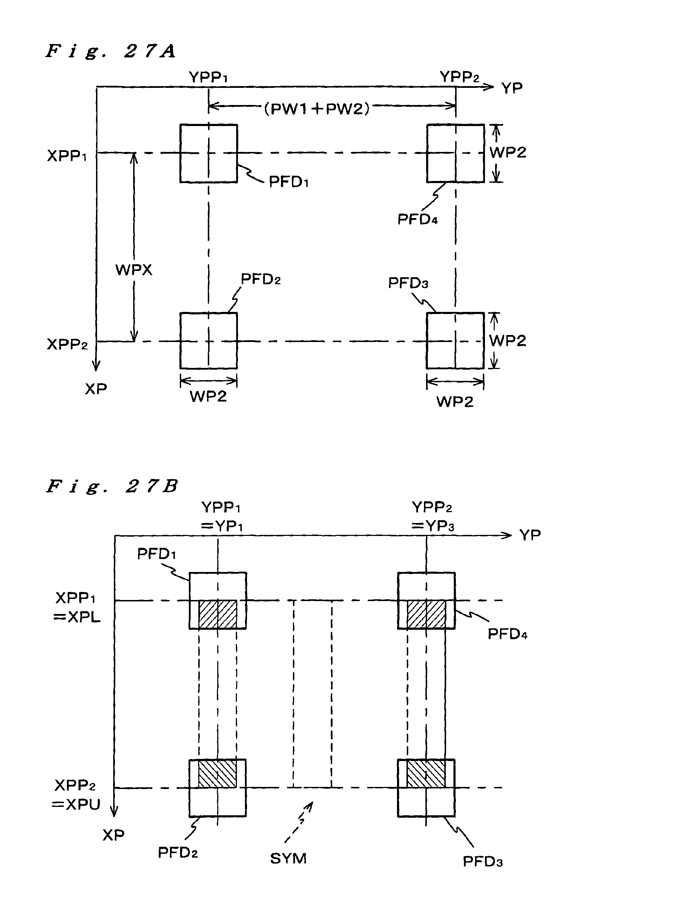

In addition, although in the second embodiment the plurality of areas $PFD_n$ (n=1 through 4) are defined as shown in Fig. 24, those may be defined as shown in Fig. 27A. That is,

a. The areas $PFD_n$ are a square having a width WP2 (>WP) in the XP and YP directions.

b. The center positions of the areas $PFD_1$, $PFD_2$, $PFD_3$, $PFD_4$ are set to be coordinates $(XPP_1, YPP_1)$, $(XPP_2, YPP_1)$, $(XPP_2, YPP_2)$, $(XPP_1, YPP_2)$ respectively, where $XPP_2=XPP_1+WPX$ and $YPP_2=YPP_1+PW1+PW2$.

c. The center coordinates $(XPP_1, YPP_1)$ of the area $PFD_1$ are variable. In this case, when the coordinates $(XPP_1, YPP_1)$ coincide with the position $(XPL, YP_1)$ as shown in Fig. 27B, there is rotational identity through 180 degrees and symmetry between image signals in areas $PFD_n$ next to each other in the XP direction; there is symmetry and translational identity between image signals in areas $PFD_n$ next to each other in the YP direction; there is rotational identity through 180 degrees between image signals in areas $PFD_n$ that are on a diagonal; and there is symmetry in the image signal in each area $PFD_n$ with respect to a line parallel to the XP direction and through its center.

In such a case, in light of symmetry or identity that occurs when the coordinates $(XPP_1, YPP_1)$ coincide with the position $(XPL, YP_1)$ as shown in Fig. 27B (e.g. rotational identity through 180 degrees between image signals in areas next to each other in the XP direction and symmetry between image signals in areas $PFD_n$ next to each other in the YP direction), degrees of coincidence between the areas and then an overall degree of coincidence are calculated and examined, so that the two-dimensional position of the image ISYM (ISθM) and thus the X-Y position of the mark SYM (SθM) can be accurately detected.

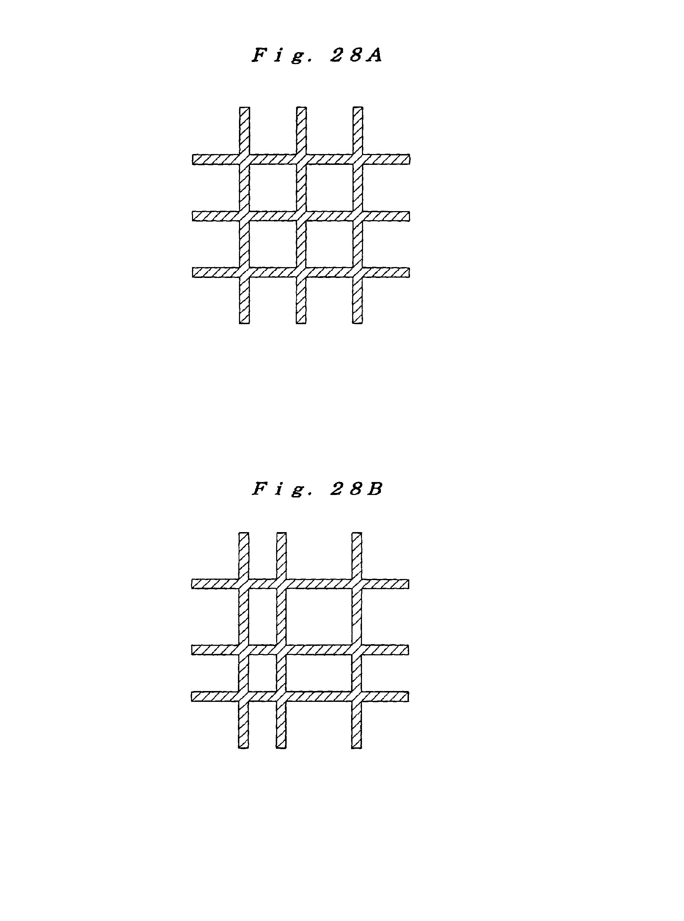

While in the second embodiment a line-and-space mark is used as a mark whose two-dimensional position is to be detected, a grid-like mark may be used that is shown in Figs. 28A or 28B. In such a grid-like mark, a plurality of areas are defined according to the grid pattern, and then by examining an overall degree of coincidence obtained from degrees of coincidence between and/or in image signals of the plurality of areas, the two-dimensional position of the mark's image and thus the X-Y position of the mark can be accurately detected. A mark other than the line-and-space mark and grid-like mark can also be used.

While in the second embodiment the two-dimensional image signals in areas are directly examined, those may be converted to one-dimensional signals to detect their positions. For example, by dividing an area into subareas the number of which is $N_X \times N_Y$, where $N_X$ indicates the number in the XP direction and $N_Y$ indicates the number in the YP direction and calculating the mean of the two-dimensional image signal in each sub-area to obtain $N_Y$ one-dimensional signals varying in the XP direction and $N_X$ one-dimensional signals varying in the YP direction and then examining degrees of coincidence between and/or in the one-dimensional signals in the plurality of areas, the two-dimensional position of the image ISYM (ISθM) and thus the X-Y position of the mark SYM (SθM) can be accurately detected.

Moreover, although in the second embodiment the product of the degrees of coincidence in four pairs of areas is taken as the overall degree of coincidence, the sum or mean of the degrees of coincidence in four pairs of areas may be used as the overall degree of coincidence as in the first embodiment.

Still further, although in the second embodiment a normalized correlation between the coordinate-transformed image signal in one area and the image signal in another area is calculated as the degree of inter-area coincidence, a. by calculating the sum of the absolute values of the differences between values at points in the coordinate-transformed image signal in the one area and values at corresponding points in the image signal in the other area, the degree of inter-area coincidence may be calculated, or b. also by calculating the sum of the squares of differences between values at points in the coordinate-transformed image signal in the one area and values at corresponding points in the image signal in the other area or the square root of the sum, the degree of inter-area coincidence may be calculated in the same way as explained in the first embodiment.

Further, in the first and second embodiments if there is similarity between the signal waveforms (or image signals) in areas, coordinate transformation plus magnification or reduction may be performed in calculating the degree of inter-area coincidence.

Still further, while in the first and second embodiments a position where the degree of coincidence is highest is searched for, a position where the degree of coincidence is lowest may be searched for depending on the shape of the mark and the area definition.

Yet further, although in the first and second embodiments it is assumed as a premise that the whole image of a mark can be picked up, if the size of the mark is larger than the pick-up field, the mark's image may be picked up by making the pick-up field scan the area including the mark, or only areas in the pick-up field may be used excluding an area out of the pick-up field in calculating the degree of coincidence, in which case instead of the area out of the pick-up field, another area in the pick-up field may be newly defined, or an overall degree of coincidence calculated with less areas may be multiplied by the original number of areas divided by the actual number.

Still further, while in the first and second embodiments it is assumed that the centerline or center position is known with respect to which the images in areas are symmetric, if not, the areas need be made to scan with changing the distances between the areas in order to calculate the degrees of coincidence.

In addition, while the first and second embodiments describe the case of a scan-type exposure apparatus, this invention can be applied to any exposure apparatus for manufacturing devices or liquid crystal displays such as a reduction-projection exposure apparatus using ultraviolet light or soft X-rays having a wavelength of about 10 nm as the light source, an X-ray exposure apparatus using light having a wavelength of about 1 nm, and an exposure apparatus using EB (electron beam) or an ion beam, regardless of whether it is of a step-and-repeat type, a step-and-scan type, or a step-and-stitching type.

In addition, while, in the first and second embodiments, position detection of search-alignment marks on a wafer and alignment of the wafer in the exposure apparatus have been described, the method for detecting marks and positions thereof and aligning according to the present invention can be applied to detecting the positions of fine alignment marks on a wafer and aligning the wafer and to detecting the positions of alignment marks on a reticle and aligning the reticle, and also to other units than exposure apparatuses such as a unit for viewing objects using a microscope and a unit used to detect the positions of objects and position them in an assembly line, process line or inspection line.

Recently, the increasingly fine patterns of semiconductor circuits have resulted in the use of a process for flattening the surfaces of layers formed on a wafer W in order to form fine circuit patterns with higher precision (flattening process). The typical one of such processes is a CMP process (Chemical and Mechanical Polishing process) in which the surface of a formed film is polished and substantially flattened. This CMP process is frequently applied to a dielectric interlayer such as silicon dioxide between wire layers (metal) of semiconductor integrated circuits.

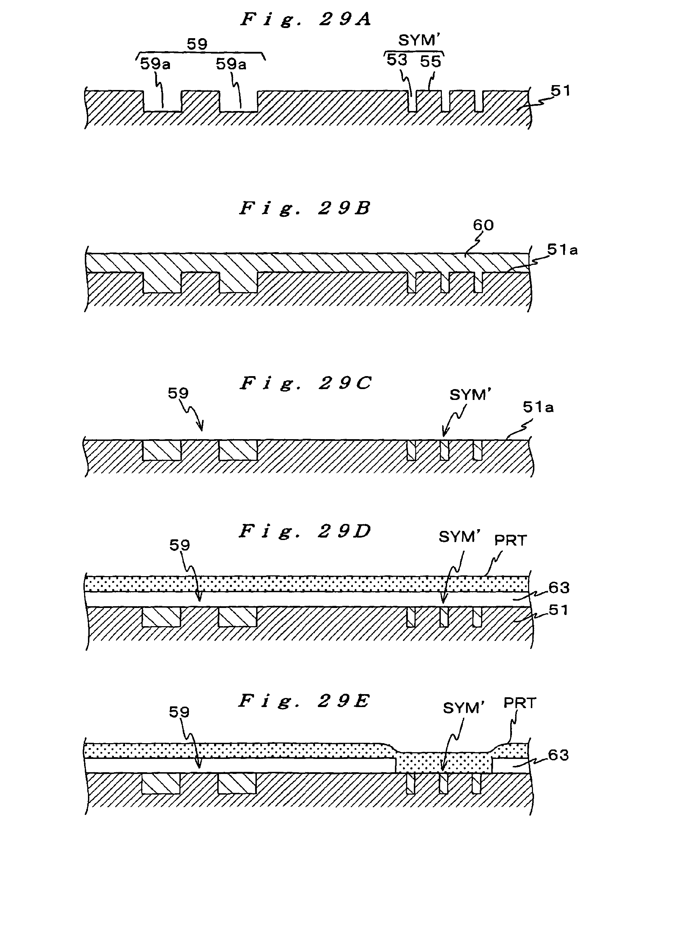

For instance, an STI (Shallow Trench Isolation) process has been developed where shallow grooves having a predetermined width are formed to insulate adjacent fine elements from each other, and the grooves are filled with a dielectric film. In the STI process, the surface of a layer in which the dielectric material is embedded is flattened by the CMP process, and poly-silicon is thereafter formed onto the resultant surface. A description will be provided of an example for the case of forming a Y-mark SYM' and other features through the foregoing process with reference to Figs. 29A to 29E.

First of all, as shown in the cross-sectional view of Fig. 29A, a Y-mark SYM' (concave portions corresponding to lines 53, and spaces 55) and a circuit pattern 59 (more specifically, concave portions 59a) are formed on a silicon wafer (substrate) 51.

Next, as shown in Fig. 29B, an insulating film 60 made of a dielectric such as silicon dioxide ($SiO_2$) is formed on a surface 51a of the wafer 51. Subsequently, as shown in Fig. 29C, the insulating film 60 is polished by the CMP process so that the surface 51a of the wafer 51 appears. As a result, the circuit pattern 59 is formed in the circuit pattern area with the concave portions 59a filled by the dielectric 60, and the mark SYM' is formed in the mark area with the concave portions, i.e. the plurality of lines 53, filled by the dielectric.

Then, as shown in Fig. 29D, a poly-silicon film 63 is formed on the upper layer of the wafer surface 51a of the wafer 51, and the poly-silicon film 63 is coated with a photo-resist PRT.

The concaves and convexes corresponding to the structure of the mark SYM' formed beneath do not appear on the surface of the poly-silicon layer 63, when the mark SYM' on the wafer 51 shown in the Fig. 29D is viewed by using the alignment system AS. A light beam having a wavelength in a predetermined range (visible light having a wavelength of 550 to 780 nm) does not pass through the poly-silicon layer 63. Therefore, the mark SYM' cannot be detected by using an alignment method which uses the visible light as the detection light for alignment. Also in an alignment method where the major part of the detection light is the visible light, the decrease of the detection accuracy may occur due to the decrease of the detected amount of the detection light.

In Fig. 29D, the metal film (metal layer) 63 might be formed instead of the poly-silicon layer 63. In this case, the concaves and convexes which reflect the alignment mark formed in the under layer do not appear at all on the metal layer 63. In general, since the detection light for the alignment does not pass though the metal layer, the mark might not be able to be detected.

When viewing the wafer 51 (shown in Fig. 29D) having the poly-silicon layer 63 formed thereon after the foregoing CMP process, the mark needs to be viewed by using the alignment system AS having the wavelength of the alignment detection light set to one other than those of visible light (for example, infrared light with a wavelength of about 800 to 1500 nm) if the wavelength of the alignment detection light can be selected or arbitrarily set.

If the wavelength of the alignment detection light cannot be selected or the metal layer 63 is formed on the wafer 51 after the CMP process, by removing the area of the metal layer (or poly-silicon layer) 63 on the mark as shown in Fig. 29E by means of photolithography, the mark can be viewed by the alignment system AS.

The θ-mark can also be formed through the CMP process in the same manner as the above-mentioned mark SYM'.


«Manufacture of devices»

Next, the manufacture of devices by using the above exposure apparatus and method will be described.

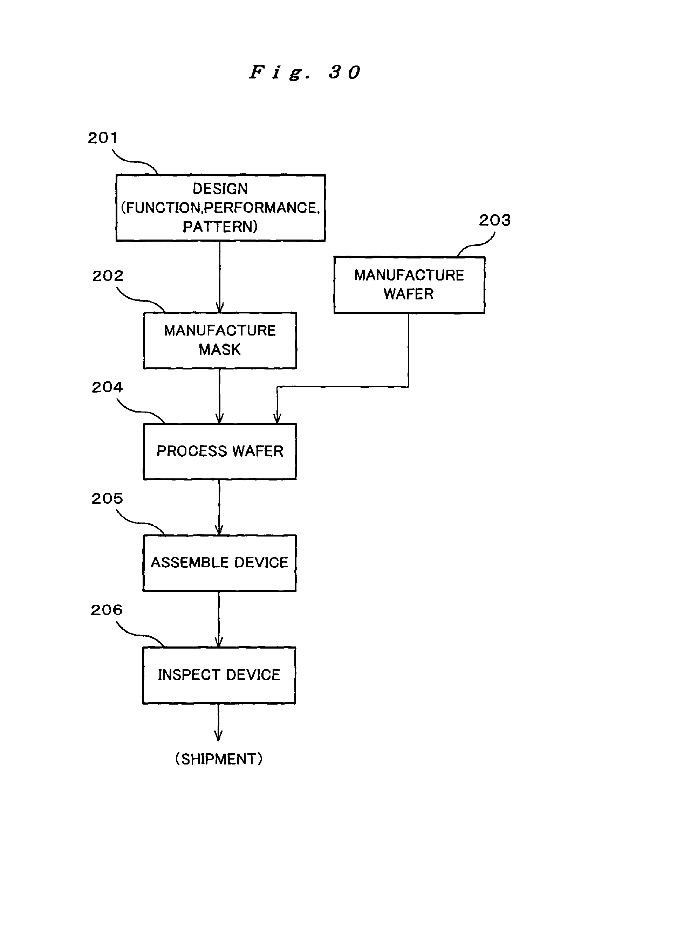

Fig. 30 is a flow chart for the manufacture of devices (semiconductor chips such as ICs or LSIs, liquid crystal panels, CCD's, thin magnetic heads, micro machines, or the like) in this embodiment. As shown in Fig. 30, in step 201 (design step), function/performance design for the devices (e.g., circuit design for semiconductor devices) is performed and pattern design is performed to implement the function. In step 202 (mask manufacturing step), masks on which a different sub-pattern of the designed circuit is formed are produced. In step 203 (wafer manufacturing step), wafers are manufactured by using silicon material or the like.

In step 204 (wafer-processing step), actual circuits and the like are formed on the wafers by lithography or the like using the masks and the wafers prepared in steps 201 through 203, as will be described later. In step 205 (device assembly step), the devices are assembled from the wafers processed in step 204. Step 205 includes processes such as dicing, bonding, and packaging (chip encapsulation).

Finally, in step 206 (inspection step), an operation test, durability test, and the like are performed on the devices. After these steps, the process ends and the devices are shipped out.

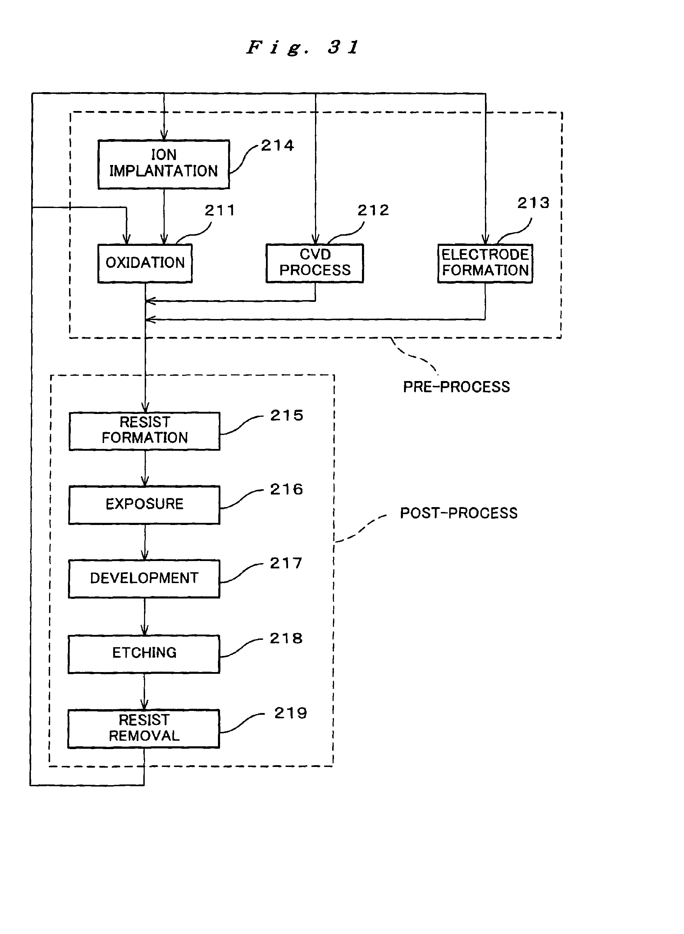

Fig. 31 is a flow chart showing a detailed example of step 204 described above in manufacturing semiconductor devices. Referring to Fig. 31, in step 211 (oxidation step), the surface of a wafer is oxidized. In step 212 (CVD step), an insulating film is formed on the wafer surface. In step 213 (electrode formation step), electrodes are formed on the wafer by vapor deposition. In step 214 (ion implantation step), ions are implanted into the wafer. Steps 211 through 214 described above constitute a pre-process, which is repeated, in the wafer-processing step and are selectively executed in accordance with the processing required in each repetition.

When the above pre-process is completed in each repetition in the wafer-processing step, a post-process is executed in the following manner. First of all, in step 215 (resist coating step), the wafer is coated with a photosensitive material (resist). In step 216, the above exposure apparatus transfers a sub-pattern of the circuit on a mask onto the wafer according to the above method. In step 217 (development step), the exposed wafer is developed. In step 218 (etching step), an uncovered member of portions other than portions on which the resist is left is removed by etching. In step 219 (resist removing step), the unnecessary resist after the etching is removed.

By repeatedly performing the pre-process and post-process, a multiple-layer circuit pattern is formed on each shot-area of the wafer.

In the above manner, the devices on which a fine dimension pattern is accurately formed are manufactured with high productivity.


## *INDUSTRIAL APPLICABILITY*

As described above, according to the position detecting method and unit of the present invention, while moving a plurality of areas having a predetermined positional relation with each other on the viewing coordinate system, the degree of inter-area coincidence in at least one pair of viewing-result parts out of viewing-result parts in the plurality of areas, based on the result of viewing an object, is calculated in light of given inter-area symmetry therein. And the position of the object is accurately detected based on the degree of inter-area coincidence, which is a function of the position of the plurality of areas in the viewing coordinate system. Therefore, the position detection method and unit of the present invention are suitable to detect the position information of the object.

Furthermore, according to the exposure method and exposure apparatus of the present invention, because the positions of alignment marks on a substrate can be accurately detected using the position detection method of the present invention, and based on the positions of the alignment marks the position information of shot areas on the substrate is calculated, a given pattern can be accurately transferred onto each shot area on the substrate while precisely controlling the position of the substrate. Therefore, the exposure method and exposure apparatus of the present invention is suitable to repeat exposure each time through a different sub-pattern with improved overlay accuracy and thus is suitable for the manufacture of devices having a fine pattern formed thereon.

**Claims**

1. A position detecting method with which to detect position information of an object, said detecting method comprising:

   a viewing step where said object is viewed;
   an area-coincidence degree calculating step where a degree of area-coincidence in a part of the viewing result in at least one area from among a plurality of areas having a predetermined positional relationship on a viewing coordinate system for said object is calculated taking into account given symmetry therein; and
   a position information calculating step where position information of said object is calculated based on said degree of area-coincidence.

2. The position detecting method according to claim 1, wherein in said viewing step a mark formed on said object is viewed, and wherein in said position information calculating step, position information of said mark is calculated.

3. The position detecting method according to claim 2, wherein said plurality of areas are determined according to the shape of said mark.

4. The position detecting method according to claim 1, wherein said degree of area-coincidence is a degree of inter-area coincidence in at least one pair of viewing-result parts from among respective viewing-result parts in said plurality of areas and taking into account given inter-area symmetry therein.

5. The position detecting method according to claim 4, wherein the number of said plurality of areas is three or greater, and wherein in said area-coincidence degree calculating step, a degree of inter-area coincidence is calculated for each of a plurality of pairs selected from said plurality of areas.

6. The position detecting method according to claim 4, wherein said area-coincidence degree calculating step comprises:

   a coordinate transforming step where coordinates of the viewing-result part in one area of which a degree of inter-area coincidence is to be calculated are transformed by use of a coordinate-transforming method corresponding to the type of symmetry defined by a relation with the other area; and
   an inter-area coincidence degree calculating step where said degree of inter-area coincidence is calculated based on the coordinate-transformed, viewing-result part in said one area and the viewing-result part in the other area.

7. The position detecting method according to claim 6, wherein, the calculating of said degree of inter-area coincidence is performed by calculating a normalized correlation coefficient between the coordinate-transformed, viewing-result part in said one area and the viewing-result part in said other area.

8. The position detecting method according to claim 6, wherein, the calculating of said degree of inter-area coincidence is performed by calculating the difference between the coordinate-transformed, viewing-result part in said one area and the viewing-result part in said other area.

9. The position detecting method according to claim 6, wherein, the calculating of said degree of inter-area coincidence is performed by calculating at least one of total variance, which is the sum of variances between values at points in the coordinate-transformed, viewing-result part in said one area and values at corresponding points in the viewing-result part in said other area, and standard deviation obtained from said total variance.

10. The position detecting method according to claim 4, wherein, in said area-coincidence degree calculating step, while moving said plurality of areas on said viewing coordinate system with keeping positional relationship between said plurality of areas, said degree of inter-area coincidence is calculated.

11. The position detecting method according to claim 4, wherein, in said area-coincidence degree calculating step, while moving said plurality of areas on said viewing coordinate system with changing positional relationship between said plurality of areas, said degree of inter-area coincidence is calculated.

12. The position detecting method according to claim 4, wherein said plurality of areas are two areas, and wherein in said area-coincidence degree calculating step, while moving said two areas in opposite directions to each other along a given axis-direction to change the distance between said two areas, said degree of inter-area coincidence is calculated.

13. The position detecting method according to claim 4, wherein, in said area-coincidence degree calculating step, for the viewing-result part in at least one area of said plurality of areas, a degree of intra-area coincidence is further calculated taking into account given symmetry therein, and wherein in said position information calculating step, position information of said object is obtained based on said degree of inter-area coincidence and said degree of intra-area coincidence.

14. The position detecting method according to claim 1, wherein said degree of area-coincidence is a degree of intra-area coincidence in at least one viewing-result part from among respective viewing-result parts in said plurality of areas and taking into account given intra-area symmetry.

15. The position detecting method according to claim 14, wherein said area-coincidence degree calculating step comprises:

   a coordinate transforming step where coordinates of the viewing-result part in an area for which said degree of intra-area coincidence is to be calculated are transformed by use of a coordinate-transforming method corresponding to said given intra-area symmetry; and
   an intra-area coincidence degree calculating step where said degree of intra-area coincidence is calculated based on said non-coordinate-transformed, viewing-result part and said coordinate-transformed, viewing-result part.

16. The position detecting method according to claim 15, wherein, the calculating of said degree of intra-area coincidence is performed by calculating a normalized correlation coefficient between said non-coordinate-transformed, viewing-result part and said coordinate-transformed viewing-result part.

17. The position detecting method according to claim 15, wherein, the calculating of said degree of intra-area coincidence is performed by calculating the difference between said non-coordinate-transformed, viewing-result part and said coordinate-transformed, viewing-result part.

18. The position detecting method according to claim 15, wherein, the calculating of said degree of intra-area coincidence is performed by calculating at least one of total variance, which is the sum of variances between values at points of said non-coordinate-transformed, viewing-result part and values at corresponding points of said coordinate-transformed, viewing-result part, and standard deviation obtained from said total variance.

19. The position detecting method according to claim 14, wherein, in said area-coincidence degree calculating step, while moving an area for which said degree of intra-area coincidence is to be calculated on said viewing coordinate system, said degree of intra-area coincidence is calculated.

20. The position detecting method according to claim 19, wherein for two or more areas said degree of intra-area coincidence is to be calculated, and wherein said two or more areas are moved on said viewing coordinate system with keeping positional relationship between said two or more areas, for which said degree of intra-area coincidence is to be calculated.

21. The position detecting method according to claim 19, wherein for two or more areas said degree of intra-area coincidence is to be calculated, and wherein said two or more areas are moved on said viewing coordinate system with changing positional relationship between said two or more areas, for which said degree of intra-area coincidence is to be calculated.

22. The position detecting method according to claim 1, wherein in said viewing step an N-dimensional image signal viewed is projected onto an M-dimensional space to obtain said viewing result, where N is a natural number of two or greater and M is a natural number smaller than N.

23. A position detecting unit which detects position information of an object, said detecting unit comprising:

   a viewing unit that views said object;

a degree-of-coincidence calculating unit that calculates a degree of area-coincidence in a part of the viewing result in at least one area from among a plurality of areas having a predetermined positional relationship on a viewing coordinate system for said object, taking into account given symmetry therein; and

a position-information calculating unit that calculates position information of said object based on said degree of area-coincidence.

24. The position detecting unit according to claim 23, wherein said viewing unit comprises a unit that picks up an image of a mark formed on said object.

25. The position detecting unit according to claim 23, wherein said degree of area-coincidence is a degree of inter-area coincidence in at least one pair of viewing-result parts from among respective viewing-result parts in said plurality of areas and taking into account given inter-area symmetry therein, and wherein said degree-of-coincidence calculating unit comprises:

a coordinate-transforming unit that transforms coordinates of the viewing-result part in one area of which a degree of inter-area coincidence is to be calculated, by use of a coordinate-transforming method corresponding to the type of symmetry defined by a relation with the other area; and

a processing unit that calculates said degree of inter-area coincidence based on the coordinate-transformed, viewing-result part in said one area and the viewing-result part in the other area.

26. The position detecting unit according to claim 23, wherein said degree of area-coincidence is a degree of intra-area coincidence in at least one viewing-result part from among viewing-result parts in said plurality of areas and taking into account given intra-area symmetry, and wherein said degree-of-coincidence calculating unit comprises:

a coordinate-transforming unit that transforms coordinates of the viewing-result part in an area for which said degree of intra-area coincidence is to be calculated, by use of a coordinate-transforming method corresponding to said given intra-area symmetry; and

a processing unit that calculates said degree of intra-area coincidence based on said non-coordinate-transformed, viewing-result part and said coordinate-transformed, viewing-result part.

27. An exposure method with which to transfer a given pattern onto divided areas on a substrate, said exposure method comprising:

a position calculating step of detecting positions of position-detection marks formed on said substrate by use of the position detecting method of claim 1 and calculating position information of said divided areas on said substrate; and

a transferring step of transferring said pattern onto said divided areas with controlling the position of said substrate based on position information of said divided areas calculated in said position calculating step.

28. An exposure apparatus which transfers a given pattern onto divided areas on a substrate, said exposure apparatus comprising:

a stage unit that moves said substrate along a movement plane; and

a position detecting unit according to claim 23 that is mounted on said stage unit and detects position of a mark on said substrate.

29. A control program which is executed by a position detecting unit that detects position information of an object, said control program comprising:

a procedure of calculating a degree of area-coincidence in a part of the viewing result in at least one area from among a plurality of areas having a predetermined positional relationship on a viewing coordinate system for said object, taking into account given symmetry therein; and

a procedure of calculating position information of said object based on said degree of area-coincidence.

30. The control program according to claim 29, wherein in said calculating of a degree of area-coincidence, a degree of area-coincidence in a result of viewing a mark formed on said object is calculated taking into account said given symmetry therein; and

wherein in said calculating of position information of said object, position information of said mark is calculated.

**31.** The control program according to claim 30, wherein said plurality of areas are determined according to the shape of said mark.

**32.** The control program according to claim 29, wherein said degree of area-coincidence is a degree of inter-area coincidence in at least one pair of viewing-result parts from among respective viewing-result parts in said plurality of areas and taking into account given inter-area symmetry therein.

**33.** The control program according to claim 32, wherein, in calculating of said degree of inter-area coincidence, while moving said plurality of areas on said viewing coordinate system with keeping positional relationship between said plurality of areas, said degree of inter-area coincidence is calculated.

**34.** The control program according to claim 32, wherein, in calculating of said degree of inter-area coincidence, while moving said plurality of areas on said viewing coordinate system with changing positional relationship between said plurality of areas, said degree of inter-area coincidence is calculated.

**35.** The control program according to claim 29, wherein said degree of area-coincidence is a degree of intra-area coincidence in at least one viewing-result part from among viewing-result parts in said plurality of areas and taking into account given intra-area symmetry.

**36.** The control program according to claim 35, wherein, in calculating of said degree of intra-area coincidence, while moving an area for which said degree of intra-area coincidence is to be calculated on said viewing coordinate system, said degree of intra-area coincidence is calculated.

**37.** The control program according to claim 35, wherein for two or more areas said degree of intra-area coincidence is to be calculated, and wherein, in said calculating of a degree of area-coincidence, said two or more areas are moved on said viewing coordinate system with keeping positional relationship between said two or more areas.

**38.** The control program according to claim 35, wherein for two or more areas a degree of intra-area coincidence is to be calculated, and wherein, in said calculating of a degree of area-coincidence, said two or more areas are moved on said viewing coordinate system with changing positional relationship between said two or more areas.

**39.** A device manufacturing method including a lithography process, wherein in said lithography process, exposure is performed by use of the exposure method of claim 27.

*Fig. 1*

*Fig. 2*

*Fig. 3A*

SL1

64

SL0

SL2

Z

X

Y

*Fig. 3B*

75

SLL

SLR

Z

Y

X

*Fig. 4*

*Fig. 5*

EP 1 333 246 A1

*Fig. 6*

101 LOAD WAFER W

102 MOVE WAFER W SUCH THAT Y-MARK SYM IS IN PICK-UP POSITION

103 MEASURE DEFOCUS AMOUNT

104 FOCUSING

105 PICK UP Y-MARK SYM

106 CALCULATE Y-POSITION OF Y-MARK SYM

107 Y-POSITION OF Y-MARK SYM CALCULATED?
N → PROCESS FOR ERROR
Y ↓

108 MOVE WAFER W SUCH THAT θ-MARK SθM IS IN PICK-UP POSITION

109 MEASURE DEFOCUS AMOUNT

110 FOCUSING

111 PICK UP θ-MARK SθM

112 CALCULATE Y-POSITION OF θ-MARK SθM

113 Y-POSITION OF θ-MARK SθM CALCULATED?
N → PROCESS FOR ERROR
Y ↓

121 CALCULATE WAFER-ROTATION θs

123 EGA ALIGNMENT

124 CALCULATE WAFER-ROTATION θ, WAFER-SCALINGS Sx, Sy, WAFER-ORTHOGONALITY ORT, AND OFFSETS Ox, Oy

125 CALCULATE OVERLAY CORRECTED POSITION

EXPOSURE PROCESS

37

Fig. 7A

Fig. 7B

## *Fig. 8*

103

START

131
COLLECT SECOND
PICK-UP DATA IMD2

132
EXTRACT SIGNAL WAVEFORM

133
CALCULATE
DEFOCUS AMOUNT IN
AREA ASL1 ON WAFER

134
CALCULATE
DEFOCUS AMOUNT IN
AREA ASL2 ON WAFER

RETURN

*Fig. 9*

*Fig. 10A*

DW1

ISL1$_R$

ISL1$_L$

WF1 | WF1

ISL2$_L$ DW2 ISL2$_R$

WF2 | WF2

YF

YF1$_0$    YF2$_0$

XF

*Fig. 10B*

DW1(DF)

DW1$_0$

O    DF

Fig. 11A

Fig. 11B

*Fig. 12*

```
                    ( START )
                        |
                        v
141 ──── ┌──────────────────────────┐
         │  SET AREAS FD1L, FD1R    │
         │    AT INITIAL POSITIONS   │
         └──────────────────────────┘
                        |
                        v  <──────────────────────────┐
142 ──── ┌──────────────────────────┐                 │
         │  TRANSFORM COORDINATES    │                 │
         │   OF SIGNAL WAVEFORM      │                 │
         │     IN AREA FD1R          │                 │
         └──────────────────────────┘                 │
                        |                              │
143 ──── ┌──────────────────────────┐                 │
         │    CALCULATE DEGREE OF    │                 │
         │  INTER-AREA COINCIDENCE   │                 │
         └──────────────────────────┘                 │
                        |                              │
                        v                              │
144 ────      ◇ AREAS FD1L, FD1R ◇     N              │
         ◇ HAVE REACHED SCAN FINAL ◇ ─────┐           │
              ◇  POSITIONS?   ◇           │           │
                        |                 │           │
                        v Y               v           │
146 ──── ┌──────────────┐  145 ─ ┌──────────────────┐ │
         │  CALCULATE    │       │ MOVE AREAS FD1L,  │ │
         │ DEFOCUS AMOUNT│       │ FD1R             │ │
         └──────────────┘       │ TO NEXT POSITIONS │ │
                |               └──────────────────┘──┘
                v
            ( RETURN )
```

133

*Fig. 13A*

*Fig. 13B*

*Fig. 13C*

*Fig. 14*

*Fig. 15A*

SYM

SMS₁   SMS₂   PRT   SMS₃   SMS₄
SML₁   SML₂   SML₃

W   51

Z
X   Y

*Fig. 15B*

IP(YP)

PW1   PW2

PPK₁   PPK₂   PPK₃

WP   WP   WP

YP₁   YP₂   YP₃   YP

*Fig. 16*

```
                    ┌──────────────┐
                    │    START     │
                    └──────┬───────┘
                           │
151 ─────┐                 ▼
         ┌─────────────────────────────────┐
         │    EXTRACT SIGNAL WAVEFORM        │          106
         └─────────────────┬───────────────┘
                           │
152 ──┐                    ▼
      ┌─────────────────────────────────┐
      │      SET AREAS PFDm              │
      │    AT INITIAL POSITIONS          │
      └─────────────────┬───────────────┘
                        │
153 ─┐                  ▼
     ┌─────────────────────────────────┐
     │  SELECT FIRST AREA PAIR (p, q)   │
     └─────────────────┬───────────────┘
                       │
154 ─┐                 ▼
     ┌─────────────────────────────────┐
     │   TRANSFORM COORDINATES OF       │
     │  SIGNAL WAVEFORM IN AREA PFDq    │
     └─────────────────┬───────────────┘
                       │
155 ─┐                 ▼
     ┌─────────────────────────────────┐
     │  CALCULATE DEGREE OF INTER-AREA  │
     │     COINCIDENCE NCFp,q           │
     └─────────────────┬───────────────┘
                       │
156 ─┐                 ▼
     <ALL AREA PAIRS SELECTED?>────N───┐         157
                 │                     ▼
                 Y        ┌─────────────────────────┐
                 │        │   SELECT NEXT AREA       │
158 ─┐           ▼        │     PAIR (p, q)          │
     ┌──────────────────┐ └─────────────────────────┘
     │  CALCULATE DEGREE OF              │
     │ INTER-AREA COINCIDENCE NCF        │
     └─────────────────┬───────────────┘
                       │
159 ─┐                 ▼
     <AREAS PFDm HAVE REACHED>────N───┐       160
     < SCAN FINAL POSITIONS? >        ▼
                 │        ┌─────────────────────────┐
                 Y        │   MOVE AREAS  PFDm       │
161 ─┐           ▼        │   TO NEXT POSITIONS      │
     ┌──────────────────┐ └─────────────────────────┘
     │  CALCULATE Y-POSITION             │
     │     OF MARK SYM                   │
     └─────────────────┬───────────────┘
                       │
                       ▼
                ┌──────────────┐
                │   RETURN     │
                └──────────────┘
```

*Fig. 17*

*Fig. 18A*

PPK₁
PW1
PPK₂
PPK₃
PW2

YPP₁
YP₁
PFD₁
PFD₂
PFD₃

*Fig. 18B*

PPK₁
PW1
PPK₂
PPK₃
PW2

YPP₁
(=YP₁)
PFD₁
PFD₂
YP
PFD₃

*Fig. 18C*

PPK₁
PW1
PPK₂
PPK₃
PW2

YPP₁
PFD₁
YP₁
PFD₂
PFD₃

*Fig. 19*

*Fig. 20A*

NC1

YP$_1$−PW/2    YP$_1$    YP$_1$+PW/2    YPP$_1$

*Fig. 20B*

NC2

YP$_1$−PW/2    YP$_1$    YP$_1$+PW/2    YPP$_1$

*Fig. 20C*

NCF'

YP$_1$    YPP$_1$

*Fig. 21*

*Fig. 22*

*Fig. 23*

106

START

171 — SET AREAS PFDn
AT INITIAL POSITIONS

172 — SELECT FIRST AREA PAIR (p, q)

173 — TRANSFORM COORDINATES OF
SIGNAL WAVEFORM IN
AREA PFDq BY ROTATING

174 — CALCULATE DEGREE OF
INTER-AREA COINCIDENCE NCFp,q

175 — ALL AREA PAIRS SELECTED?    N    176

SELECT NEXT AREA
PAIR (p, q)

Y

177 — CALCULATE DEGREE OF
INTER-AREA COINCIDENCE NCF

178 — AREAS PFDn HAVE REACHED
SCAN FINAL POSITIONS?    N    179

MOVE AREAS PFDn
TO NEXT POSITIONS

Y

180 — CALCULATE XY-POSITION
OF MARK SYM

RETURN

## Fig. 24

## Fig. 25

*Fig. 26*

*Fig. 27A*

*Fig. 27B*

Fig. 28A

Fig. 28B

## Fig. 29A

59
59a    59a                                    SYM'
                                            53   55

51

## Fig. 29B

60
51a

## Fig. 29C

59                                           SYM'         51a

## Fig. 29D

59                                    SYM'    PRT
                                                         63
                                                         51

## Fig. 29E

59                                    SYM'    PRT

63

## *Fig. 30*

201
DESIGN
(FUNCTION,PERFORMANCE,
PATTERN)

203
MANUFACTURE
WAFER

202
MANUFACTURE
MASK

204
PROCESS WAFER

205
ASSEMBLE DEVICE

206
INSPECT DEVICE

(SHIPMENT)

*Fig. 31*

## INTERNATIONAL SEARCH REPORT

| International application No. |
| --- |
| PCT/JP01/09219 |

**A. CLASSIFICATION OF SUBJECT MATTER**
Int.Cl⁷ G01B21/00, H01L21/027, G03F7/20

According to International Patent Classification (IPC) or to both national classification and IPC

**B. FIELDS SEARCHED**

Minimum documentation searched (classification system followed by classification symbols)
Int.Cl⁷ G01B21/00, H01L21/027, G03F7/20

Documentation searched other than minimum documentation to the extent that such documents are included in the fields searched
Jitsuyo Shinan Koho 1922-1996 Toroku Jitsuyo Shinan Koho 1994-2002
Kokai Jitsuyo Shinan Koho 1971-2002 Jitsuyo Shinan Toroku Koho 1996-2002

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 11-288867 A (Nikon Corporation), 19 October, 1999 (19.10.99), Full text; all drawings (Family: none) | 1-39 |
| A | JP 11-97512 A (Nikon Corporation), 09 April, 1999 (09.04.99), Full text; all drawings (Family: none) | 1-39 |

☐ Further documents are listed in the continuation of Box C. ☐ See patent family annex.

| * | Special categories of cited documents: |
| --- | --- |
| "A" | document defining the general state of the art which is not considered to be of particular relevance |
| "E" | earlier document but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search 21 January, 2002 (21.01.02) | Date of mailing of the international search report 29 January, 2002 (29.01.02) |
| --- | --- |
| Name and mailing address of the ISA/ Japanese Patent Office | Authorized officer |
| Facsimile No. | Telephone No. |

Form PCT/ISA/210 (second sheet) (July 1992)